(19) **Europäisches Patentamt / European Patent Office / Office européen des brevets**

(11) **EP 4 014 483 B1**

(12) # EUROPEAN PATENT SPECIFICATION

(45) Date of publication and mention
of the grant of the patent:
**20.05.2026 Bulletin 2026/21**

(21) Application number: **20852196.3**

(22) Date of filing: **12.08.2020**

(51) International Patent Classification (IPC):
**H04N 13/307** *(2018.01)*    **G02B 30/26** *(2020.01)*
**G02B 27/01** *(2006.01)*    **G02B 30/10** *(2020.01)*

(52) Cooperative Patent Classification (CPC):
**H04N 13/307; G02B 30/23; H04N 13/344**

(86) International application number:
**PCT/US2020/045921**

(87) International publication number:
**WO 2021/030430 (18.02.2021 Gazette 2021/07)**

(54) **OPTICAL DESIGN AND OPTIMIZATION TECHNIQUES FOR 3D LIGHT FIELD DISPLAYS**

OPTISCHE ENTWURFS- UND OPTIMIERUNGSTECHNIKEN FÜR 3D-LICHTFELDANZEIGEN

TECHNIQUES DE CONCEPTION ET D'OPTIMISATION OPTIQUES POUR AFFICHAGES À CHAMP LUMINEUX 3D

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.08.2019 US 201962885460 P**

(43) Date of publication of application:
**22.06.2022 Bulletin 2022/25**

(73) Proprietor: **Arizona Board of Regents on behalf of the**
**University of Arizona**
**Tuscon, AZ 85721 (US)**

(72) Inventors:
• **HUA, Hong**
  **Tucson, Arizona 85721 (US)**
• **HUANG, Hekun**
  **Tucson, Arizona 85721 (US)**

(74) Representative: **Lind Edlund Kenamets**
**Intellectual Property AB**
**Kungsportsavenyn 25**
**411 36 Göteborg (SE)**

(56) References cited:
**WO-A1-2018/165117**    **US-A1- 2015 049 390**
**US-A1- 2015 178 923**    **US-A1- 2017 078 652**

• HUANG HEKUN ET AL: "Effects of ray position sampling on the visual responses of 3D light field displays", vol. 27, no. 7, 18 March 2019 (2019-03-18), pages 9343 - 9360, XP055792907, Retrieved from the Internet <URL:https://www.osapublishing.org/viewmedia.cfm?URI=oe-27-7-9343> [retrieved on 20210407], DOI: 10.1364/OE.27.009343

• HUANG HEKUN ET AL: "Systematic characterization and optimization of 3D light field displays", vol. 25, no. 16, 24 July 2017 (2017-07-24), pages 18508, XP055792909, Retrieved from the Internet <URL:https://www.osapublishing.org/viewmedia.cfm?URI=oe-25-16-18508> [retrieved on 20210407], DOI: 10.1364/OE.25.018508

• HUANG HEKUN ET AL: "High-performance integral-imaging-based light field augmented reality display using freeform optics", vol. 26, no. 13, 21 June 2018 (2018-06-21), pages 17578, XP055852450, Retrieved from the Internet <URL:https://www.osapublishing.org/viewmedia.cfm?URI=oe-26-13-17578> [retrieved on 20211018], DOI: 10.1364/OE.26.017578

- **HUANG HEKUN ET AL: "Generalized methods and strategies for modeling and optimizing the optics of 3D head-mounted light field displays", vol. 27, no. 18, 21 August 2019 (2019-08-21), pages 25154, XP055792910, Retrieved from the Internet <URL:https://www.osapublishing.org/viewmedia.cfm?URI=oe-27-18-25154> [retrieved on 20210407], DOI: 10.1364/OE.27.025154**
- **HUANG HEKUN, HUA HONG: "Effects of ray position sampling on the visual responses of 3D light field displays", OPTICS EXPRESS, vol. 27, no. 7, 18 March 2019 (2019-03-18), pages 9343 - 9360, XP055792907, DOI: https://doi.org/10.1364/OE.27.009343**
- **HUANG HEKUN, HUA HONG: "Systematic characterization and optimization of 3D light field displays", OPTICS EXPRESS, vol. 25, no. 16, 24 July 2017 (2017-07-24), pages 18508 - 18525, XP055792909, DOI: https://doi.org/10.1364/OE.25.018508**
- **HUANG HEKUN, HUA HONG: "Generalized methods and strategies for modeling and optimizing the optics of 3D head-mounted light field displays", OPTICS EXPRESS, vol. 27, no. 18, 21 August 2019 (2019-08-21) - 2 September 2019 (2019-09-02), pages 25154 - 25171, XP055792910, DOI: https://doi.org/10.1364/OE.27.025154**

**Description**

**CROSS REFERENCE TO RELATED APPLICATIONS**

This application claims priority to the U.S. provisional application with serial number 62/885,460 titled "Optical Design and Optimization Techniques for 3D Light Field Displays," filed August 12, 2019.

**STATEMENT REGARDING FEDERALLY SPONSORED RESEARCH**

This invention was made with government support under Grant No. 1422653, awarded by NSF. The government has certain rights in the invention.

**TECHNICAL FIELD**

The disclosed technology generally relates to three-dimensional (3D) displays, and more specifically to methods and frameworks for designing and optimizing high-performance light field displays.

**BACKGROUND**

Conventional stereoscopic three-dimensional displays (S3D) stimulate the perception of 3D spaces and shapes from a pair of two-dimensional (2D) perspective images at a fixed distance, one for each eye, with binocular disparities and other pictorial depth cues of a 3D scene seen from two slightly different viewing positions. A key limitation associated with the S3D-type displays is the well-known vergence-accommodation conflict (VAC) problem. With binocular vision, when observing an object, the eyes must rotate around a horizontal axis so that the projection of the image is in the center of the retina in both eyes. Vergence is the simultaneous movement of both eyes in opposite directions to obtain or maintain single binocular vision. Accommodation is the process by which the eye changes optical power to maintain a clear image or focus on an object as its distance varies. Under normal viewing conditions of objects, changing the focus of the eyes to look at an object at a different distance will automatically cause vergence and accommodation. In the context of 3D displays, the VAC occurs when the brain receives mismatching cues between the distance of a virtual 3D object (vergence), and the focusing distance (accommodation) required for the eyes to focus on that object. This issue stems from the inability to render correct focus cues, including accommodation and retinal blur effects, for 3D scenes. It causes several cue conflicts and is considered as one of the key contributing factors to various visual artifacts associated with viewing S3D displays Related background art - "Effects of ray position sampling on the visual responses of 3D light field displays",Huang Hekun et al, OPTICS EXPRESS, vol. 27, no. 7, 18 March 2019.

"Systematic characterization and optimization of 3D light field displays", Huang Hekunet al OPTICS EXPRESS, vol. 25, no. 16, 24 July 2017.

**SUMMARY OF CERTAIN ASPECTS**

The disclosed embodiments relate to three-dimensional (3D) displays, and more specifically to methods and frameworks for designing and optimizing of high-performance light field displays, including but not limited to light field head-mounted displays.

The invention relates to a method for designing and optimizing an integral-imaging (InI) based three-dimensional (3D) display system as set out in claim 1. The system includes an arrayed optics, an arrayed display device capable of producing a plurality of elemental images, a first reference plane representing a virtual central depth plane (CDP) on which light rays emitted by a point source on the display converge to form an image point, a second reference plane representing a viewing window for viewing a reconstructed 3D scene, and an optical subsection representing a model of a human eye. The method for designing the system includes tracing a set of rays associated with a light field in the InI-based 3D system, where the tracing starts at the arrayed display device and is carried out through the arrayed optics and to the optical subsection for each element of the arrayed display device and arrayed optics. The method further includes adjusting one or more parameters associated with the InI-based 3D system to obtain at least a first metric value within a predetermined value or range of values. The first metric value corresponds to a ray directional sampling of the light field.

In the disclosed InI-based 3D systems, light field reconstructs the 4-D light field of a 3D scene by angularly sampling the directions of the light rays apparently emitted by the 3D scene. According to some embodiments, the optical design process includes optimizing the mapping of both ray positions and ray directions in 4-D light field rendering rather than simply optimizing the 2D mapping between object-image conjugate planes in conventional HMD designs.

## BRIEF DESCRIPTION OF THE DRAWINGS

FIG. 1A is an example of a conventional head-mounted display (HMD) configuration that renders a tow-dimensional (2D) image on a microdisplay to form a sharp-focus retinal image.

FIG. 1B illustrates the conventional HMD configuration as shown in FIG 1A when the accommodation depth is displaced from the distance of the virtual display.

FIG. 2A is an example configuration illustrating the image formation process of an integral-imaging based HMD (InI-HMD) for light field reconstruction for a first accommodation depth.

FIG. 2B illustrates the configuration of FIG. 2A and image formation corresponding to a second accommodation depth.

FIG. 3A illustrates mapping of a light field function and associated notations for a integral-imaging based HMD (InI-HMD) configuration.

FIG. 3B illustrates the optical principle of reconstructing the 3D scene of an InI-based light field 3D display.

FIG. 4A illustrates a three-dimensional view of the various aspects of the InI-HMD system that includes footprints on the viewing window and imaged apertures of lenslets of the microlens array (MLA).

FIG. 4B illustrates the division of elemental images (EIs) on the microdisplay associated with the InI-HMD system.

FIG. 4C illustrates a sub-system including an EI, a lenslet of MLA and the shared eyepiece group.

FIG. 4D illustrates partially overlapped virtual images of four EIs on the virtual central depth plane (CDP).

FIG. 4E illustrates the partially overlapped virtual images of the EIs on the CDP as illustrated in FIG. 4D with certain features removed to enhance clarity.

FIG. 5 illustrates the effects of a global deviation metric regarding the global distortion in ray positions upon full field distortion grid for an example InI-HMD system.

FIG. 6 illustrates the effects of deformation of the ray footprint of a given ray bundle from its paraxial shape for an example InI-HMD system.

FIG. 7A illustrates an example layout of a binocular InI-HMD system designed in accordance with the disclosed technology.

FIG. 7B illustrates further details regarding the optical layout of a section of FIG. 7A.

FIG. 8A illustrates a plot of image contrast of the display path associated with an example InI-HMD system

FIG. 8B illustrates modulation transfer function (MTF) plots for on-axis field points corresponding to a subset of sampled lenslets covering the field of view of an example InI-HMD system.

FIG. 8C illustrates MTF plots for on-axis field points of each EI corresponding to the central lenslets with their virtual CDP sampled from 3 diopters to 0 diopters away from the viewing window of an example InI-HMD system.

FIG. 9A illustrates a plot of distortion grid of display path covering the full field for an example InI-HMD system.

FIG. 9B illustrates a footprint diagram at the viewing window before optimization of pupil aberration of the example InI-HMD system.

FIG. 9C illustrates a footprint diagram at the viewing window after optimization of pupil aberration of the example InI-HMD system.

FIG. 10 illustrates a set of operations for designing an InI-based 3D display system in accordance with an example embodiment.

FIG. 11 illustrates a set of operations for improving design of an integral imaging optical system in accordance with an example embodiment.

FIG. 12 illustrates a block diagram of a device that can be used to implement certain aspects of the disclosed technology.

## DETAILED DESCRIPTION

There have been several efforts to address the vergence-accommodation conflict (VAC) problem, among them is an integral-imaging-based (InI-based) light field 3D (LF-3D) display. Integral imaging generally refers to a three-dimensional imaging technique that captures and reproduces a light field by using a two-dimensional array of microlenses or optical apertures. This configuration allows the reconstruction of a 3D scene by rendering the directional light rays apparently emitted by the scene via an array optics seen from a predesigned viewing window. However, a systematic design approach suitable for the optimization of 3D display systems, including InI-based LF-3D head-mounted displays (HMDs), is lacking. As such, designing high-performance 3D display systems remain to be a challenge. In particular, without a well-optimized design, an InT-HMD will not be able to correctly render the depth and accommodation cue of the reconstructed 3D scene, resulting in images of compromised quality and comfort.

In the description that follows, the InI-HMD is used as an example system to illustrate the above noted problems and the disclosed solutions. It is, however, understood that the disclosed embodiments are similarly applicable to other types of 3D display systems, such as non-head-worn, direct-view type light field displays, where the optical systems for rendering light fields are not directly worn on a viewer's head, 3D light field displays that only sample the light field in one angular direction, typically in the horizontal direction, (which is better known as displays rendering horizontal parallax only - i.e., multi-views are arranged in as vertical stripes on the viewing window), or super multi-view displays or autostereoscopic displays where the elemental views are generated by an array of projectors or imaging units.

In systems that utilize integral imaging, a 3D image is typically displayed by placing a microlens array (MLA) in front of the image, where each lenslet of the MLA looks different depending on the viewing angle. An InI-HMD system requires that different elemental views created by multiple elements of the MLA to be rendered and be seen through each of the eye pupils. Therefore, the light rays emitted by multiple spatially-separated pixels on these elemental views are received by eye pupil and integrally summed up to form the perception of a 3D reconstructed point, which essentially is the key difference of an InI-HMD from a conventional HMD. In a conventional HMD system, the viewing optics simply project a 2D image on a microdisplay onto a 2D virtual display and thus the light rays from a single pixel are imaged together by the eye optics to form the perception of a 2D point. Due at least to this inherent difference of the image formation process, the existing optical design methods for conventional HMDs become inadequate for designing a true 3D LF-HMD system which requires the ray integration from multiple individual sources.

The disclosed embodiments, among other features and benefits, provide improved optical design methods that enable (1) producing an LF-3D HMD design to precisely execute real ray tracing, and (2) optimize the design to precisely sample and render the light field of a reconstructed 3D scene, which is key to drive the accommodation status of the viewer's eye and thus solve the VAC problem. In embodiments of the disclosed technology, one or more new design constraints or metrics are established that facilitate the optimization of ray positional sampling of the light field and/or ray directional sampling of the light field. For instance, one constraint or metric for positional sampling accounts for global distortions (e.g., aberrations) related to the lateral positions of the virtual elemental images (EIs) with respect to the whole FOV of the reconstructed 3D scene aberrations. Another constraint or metric for directional sampling provides a measure of deviation or deformation of the ray footprints from their paraxial shapes.

The use of the disclosed constraints and metrics improves the optical design process, and allows a designer to assess the quality of the produced images (e.g., in terms of solving the VAC problem) and improve the design of the optical system. In some embodiments, by minimizing the disclosed metrics during the design process, an optimum design may be produced. The disclosed metrics further provide an assessment of achievable image quality, and thus, in some embodiments, a desired image quality goal may be achieved for a particular optical system based on target values (as opposed to minimization) of the disclosed metrics.

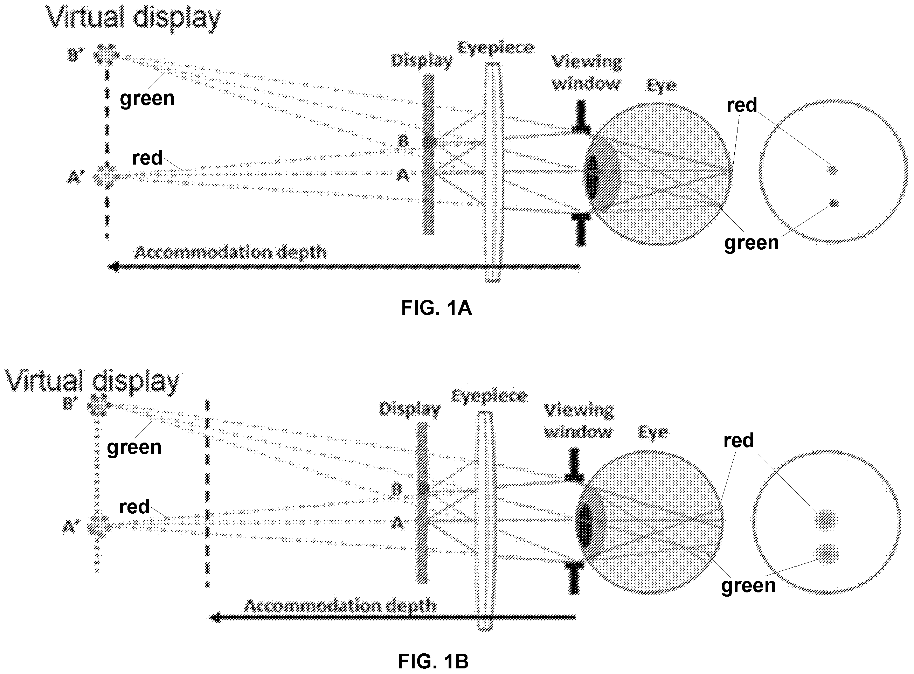

FIGS. 1A and 1B illustrate an example conventional HMD configuration that renders a 2D image on a microdisplay. Similar to other 2D displays, each pixel value represents the intensity or radiance sum of the light rays over an angular range. An eyepiece inserted between the microdisplay (labeled as "Display" in FIGS 1A and 1B) and the eye simply magnifies the 2D image and forms a magnified 2D virtual display at a distance optically conjugate to the microdisplay plane via the eyepiece. Therefore, all of the light rays from a single pixel are imaged together by the eye optics to form the perception of a 2D point. In FIGS. 1A and 1B the "red" and "green" labels are used to facilitate the illustration of different ray bundles that propagate through the system. When the accommodation depth of the eye optics matches with the apparent distance of the virtual display, a sharp-focus retinal image is formed, as shown in FIG. 1A. Otherwise, as shown in FIG. 1B, an equally blurred retinal image is formed when the accommodation depth is displaced from the distance of the virtual display.

Owning to the nature of 2D image formation described above, the optical design process for such a system only needs to focus on the 2D mapping between the pixels on a microdisplay and their corresponding images on the virtual display; the optimization strategy concentrates on control of optical aberrations that degrade the contrast and resolution of the virtual display or detort the geometry of the virtual display. To this end, the rays from every single pixel on the display are imaged by a common optical path or sequence of optical elements. Therefore, the conventional HMD system can be modeled by a shared optical configuration. In such a system, the retinal image of a rendered point is the projection of the rays emitted by a single pixel on the microdisplay or the magnified virtual display, allowing the optical performance of a conventional 2D HMD system to be adequately evaluated by characterizing the 2D image patterns projected by the rays from a handful field positions on the microdisplay.

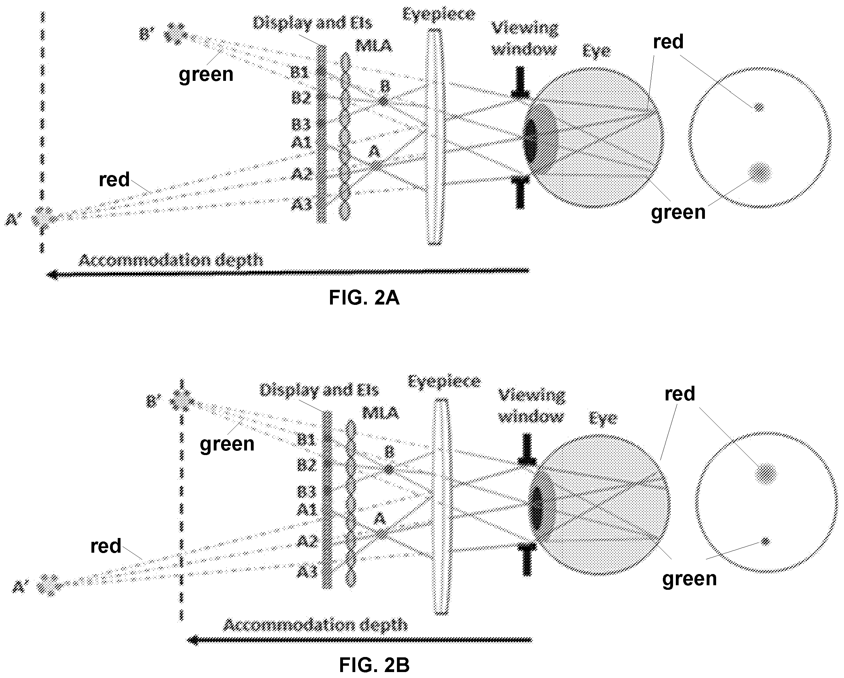

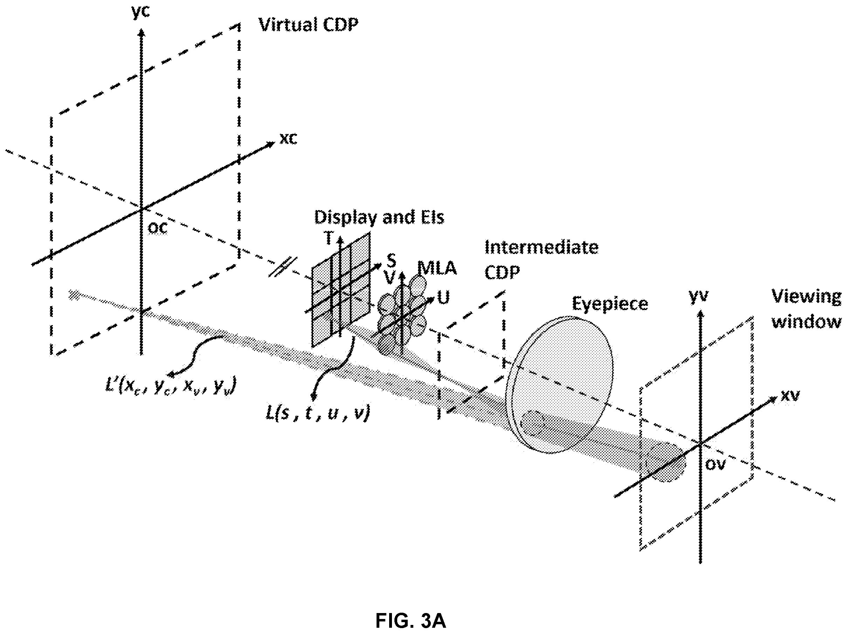

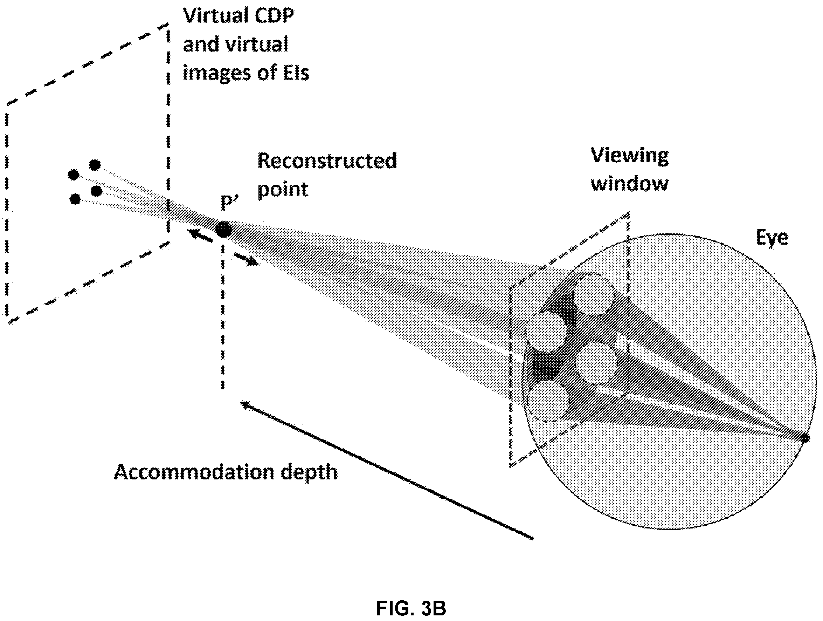

In contrast, an LF-HMD reconstructs the 4-D light field of a 3D scene by angularly sampling the directions of the light rays apparently emitted by the 3D scene. FIGS. 2A and 2B is an example configuration that illustrates the image formation process of an integral-imaging based HMD (InI-HMD) for light field reconstruction. FIGS. 3A and 3B illustrate a three-dimensional view of the same system further notations to facilitate the understanding of the light field function. As illustrated in FIG. 2A, the system includes a microdisplay, an array optics (e.g., a lenslet array) and an eyepiece. In FIG. 2A, elemental images (EIs) of the 2D array represent a different perspective of a 3D scene rendered on the microdisplay (e.g., elements A1 to A3 are used for reconstructed point A; elements B1 to B3 for reconstructed point B). There are two unique and important conceptual reference planes in InI-HMDs that are widely recognized. The first plane is the virtual central depth plane (CDP) on which the light rays emitted by a point source on the microdisplay converge to form an image point after propagating through the MLA and eyepiece (see also FIG. 3A). It is viewed as the plane of reference in the visual space optically conjugate to the microdisplay. The second reference plane is the viewing window defining the area within which a viewer observes the reconstructed 3D scene. It coincides with the entrance pupil plane of the eye optics by design and is commonly known as the exit pupil or eye box of the system in a conventional HMD.

Each pixel on these EIs is considered as the image source defining the positional information, $(s, t)$, of the 4-D light field function. Associated with the array of EIs is an array optics, such as an MLA, each of which defines the directional information, $(u, v)$, of the light field function (see, also FIG. 3A, which illustrates the 4-D light field, including parameters $s$, $t$, $u$, $v$). Each 2D EI is imaged by its corresponding microlenslet as a separate imaging path. To reconstruct the light field of a 3D point, the ray bundles emitted by multiple pixels (each on a different EI) are modulated by their corresponding MLA elements to intersect at the 3D position of reconstruction. As a result, lights rays from these spatially separated pixels integrally create the 3-D point that appears to emit light in different directions. By correctly arranging the EIs on the display panel, the 4-D light field of a 3D scene with points (e.g., points A and B in FIGS. 2A and 2B) located at different field angle and depth can thus be correspondingly rendered.

In a magnified-view configuration, an eyepiece is inserted to further magnify the miniature 3D scene into a large 3D volume with an extended depth in virtual space (e.g., A' and B' in FIGS. 2A and 2B are the magnified renderings of the reconstructed points A and B, respectively). In a true LF-3D HMD, multiple elemental views from a 3D point are projected at different locations on the entrance pupil of the eye and the retinal images of these elemental views integrally form the perception of a 3D point in space. When the eye is accommodated at the depth of the reconstructed point A', as illustrated in FIG. 2A, the rays from its corresponding elemental pixels (e.g., pixels A1 to A3) will overlap with each other and naturally form a sharply focused image on the retina, while the rays from pixels reconstructing point B' (e.g., rays from pixel B1 to B3), which are located at a different depth from point A, will be spatially displaced from each other and create a retinal blur. The apparent amount of retinal blur of point B varies with the difference between the depths of reconstruction and eye accommodation. As illustrated in FIG. 2B, when the eye accommodation depth is switched to point B', the retinal image of point B' becomes in-focus while the retinal image of point A' become blurry. Under such circumstances, the retinal image of the reconstructed 3D scene by an InI-HMD will approximate the visual effects of viewing a natural 3D scene.

Owning to the nature of 3D image formation described above, light field reconstruction of a 3D point is the integral effects of the light rays emitted by multiple spatially separated pixels, each of which is located on a different elemental image and imaged by a different optics unit of an array optics. Each pixel provides a sample of a light field position and its corresponding unit of imaging optics provides a sample of a light field direction. Therefore, the optical design process requires optimizing the mapping of both ray positions and directions in 4-D light field rendering rather than simply optimizing the 2D mapping between object-image conjugate planes in conventional HMD designs. The optimization strategy needs to not only properly control and evaluate optical aberrations that degrade the contrast and resolution of the virtual display or detort the geometry of the 2D elemental images, which accounts for the ray position sampling aspects of the light field, but also requires methods and metrics to control and evaluate the optical aberrations that degrade the accuracy of the directional ray sampling.

As illustrated in FIG. 3A, the pixels on different elemental images are imaged by different optical paths through different optical elements. Therefore, the LF-HMD system needs to be modeled by a multi-configuration array system or an array of sub-systems distributed in the horizontal and vertical directions. Each of the sub-systems represents one single imaging path from a given elemental image through its corresponding optics unit and a perhaps eyepiece group if there is one. It should be noted that to clearly differentiate the shapes of EIs from lenslets, for the purpose of illustrations, circular shapes are used to represent the apertures of the lenslets and their corresponding footprints on the viewing window, while square apertures have been utilized for the lenslets in the examples provided herein.

The retinal image of a rendered 3D point is the integral sum of the projected rays emitted by multiple pixels on different elemental images, and the appearance of the image varies largely with the states of the eye accommodation. Therefore, the optical performance of an LF-HMD system cannot be adequately evaluated by characterizing the 2D image patterns projected by the rays from a handful field positions on the microdisplay alone, but needs to be evaluated by charactering the integral images on the retina with respect to different states of eye accommodation. For this purpose, an eye model is a necessary part of the imaging system.

FIG. 3A further illustrates a simplified process of light field rendering in the visual space, where the ray positions of the light field function are sampled by the projected virtual pixels $(x_c, y_c)$ on the virtual CDP and the ray directions are defined by the projected coordinates $(x_v, y_v)$ of the array elements on the viewing window. Theoretically, with the ideal light field function $L'(x_c, y_c, x_v, y_v)$ rendered by an InI-HMD, the corresponding EIs reconstructing a light field point will be imaged as point sources on the virtual CDP, and their ray bundles will perfectly intersect at the lateral and longitudinal position of the point and projected at their corresponding viewing zones on the viewing window as illustrated in FIG. 3B. It should be noted that distinctively different from a conventional HMD, the ray bundles emitted by the elemental pixels that reconstruct a 3D point are projected onto different locations at the view window as shown in FIG. 3B. Any deviation in rendering the light field function due to the imperfection of the imaging process of an InI-HMD, however, will lead to compromised EIs on the virtual CDP and/or wrong directions and footprints of the ray bundles projected onto the viewing window. Consequently, such deviation leads to compromised reconstruction of the 3D scene and reduced perceived image quality of an InI-HMD by the viewer. Therefore, in designing an InI-HMD system, the light fields, L($s, t, u, v$), physically rendered by a display panel -arid the MLA in the object space must be mapped accurately into the light fields, L'($x_c, y_c, x_v, y_v$), viewed by the eye in the visual space.

To achieve a good mapping, it is critical to obtain (1) a good control of the positional sampling mapping from ($s, t$) to ($x_c, y_c$) of the light field function so that each of the EIs rendered on the display panel is well imaged onto the virtual CDP, and (2) a good control of the directional sampling mapping from ($u, v$) to ($x_v, y_v$) of the light field function so that the ray bundles from each of the imaged EIs are projected onto the viewing window with the correct directions and footprints and thus the elemental views are well integrated without displacement from each other.

In particular, in optimizing the ray position mapping from ($s, t$) to ($x_c, y_c$) additional considerations regarding interactions between induvial elements must be taken into account. Further, optimizing the ray direction mapping from ($u, v$) to ($x_v, y_v$) requires completely new design metrics capable of precisely evaluating the quality of the directional sampling of the reconstructed light field of a 3D scene and its effect upon the display system.

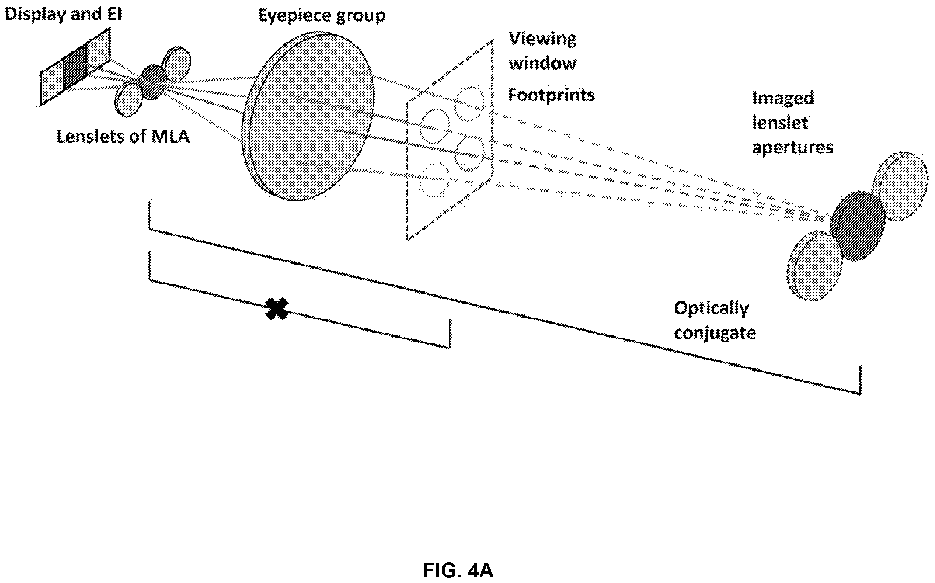

FIGS. 4A to 4D illustrate a three-dimensional view of the various aspects of the InI-HMD system, including footprints on viewing window and imaged apertures of lenslets of MLA (real exit pupil), and the division of EIs on the microdisplay. It is noteworthy that in some of InI-HMD systems, more optical elements that are capable of further improving the overall display performance, such as tunable relay group, can be added in the display path, which adds more complexity in designing InI-HMDs but can still follow the same design methodology as a system consisting of only an eyepiece. Without the loss of generality, in some instances, these added optical elements can be combined with the eyepiece and are referred to as "eyepiece group" herein.

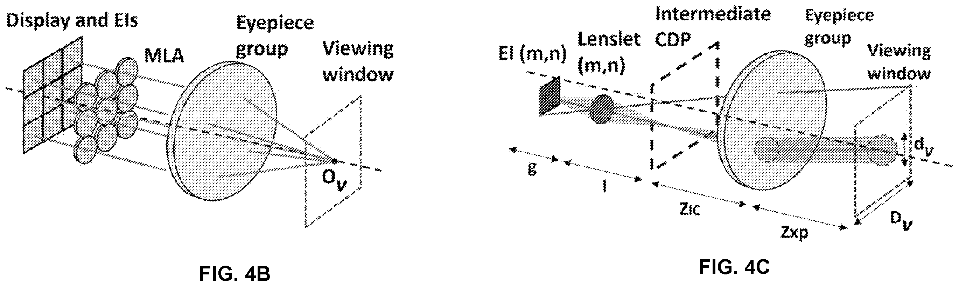

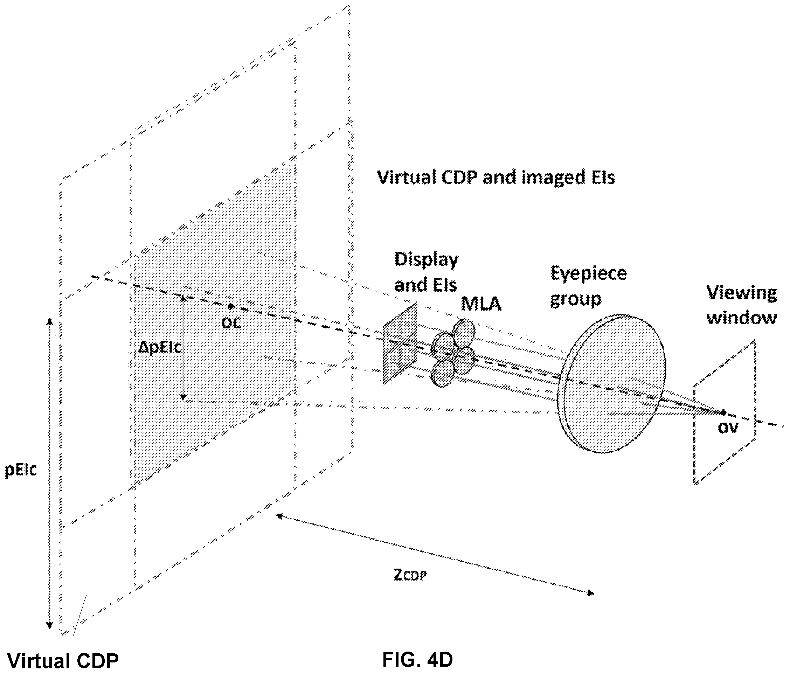

FIG. 4A illustrates footprints on the viewing window and imaged apertures of lenslets of the MLA (real exit pupil). The LF-HMD system can be divided into M by N sub-systems, where M and N are the total number of optics units in the array optics or equivalently the number of EIs rendered on the microdisplay in the horizontal and vertical directions, respectively. FIG. 4B illustrates the division of EIs on the microdisplay. FIG. 4C illustrates a sub-system including an EI, a lenslet of MLA and the shared eyepiece group. Each of the sub-systems represents one single imaging path from an EI through its corresponding optics unit of the array optics and a shared eyepiece group. The imaging path of each sub-system is off-axis, non-rotational symmetric to the main optical axis as illustrated in FIG. 4C. Each of the sub-systems may be configured as a zoom configuration in optical design software. FIG. 4D illustrates partially overlapped virtual images of EIs on the virtual CDP.

In conventional 2D HMD designs, HMD optical systems are commonly configured to trace rays reversely from a shared exit pupil (or the entrance pupil of the eye) toward the microdisplay, and no eye model is needed. In contrast, the sub-systems in accordance with the disclosed embodiments are configured such that the ray tracing starts from the microdisplay or equivalently from the EI toward the viewing window. In this way, ray tracing failures are avoided due to the fact that the projections of the array of apertures of the optics unit of array optics on the viewing window do not form a commonly-shared exit pupil as in conventional HMDs. Additionally, an ideal lens emulating the eye optics of a viewer or an established eye model (e.g., the Arizona eye model) is inserted with its entrance pupil coinciding with the viewing window for better optimization convergence and convenient assessment of the retinal image of a light field reconstruction. It should be noted that the use of a standard eye model is one non-limiting example that allow the design of the 3D system for mass-produced products. In some embodiments, an individualized or customized eye model may be used.

Referring back to FIGS. 4A to 4D, the zoom configurations among the sub-systems mainly differ from each other by the surface shape prescriptions and lateral position of the corresponding optics unit as well as the lateral position of the corresponding EI with respect to the optical axis of the eyepiece group. In one embodiment, all the lenslets in the MLA have identical surface shapes and are arranged in a rectangular array with equal lens pitch in both horizontal and vertical directions. For this embodiment, the lateral position of each lenslet, ($u, v$), is solely determined by the displacement between the neighboring lenslet, $\Delta p_{MLA}$, or equivalently the lens pitch $p_{MLA}$, and the arrangement of the lenslets. Following the same coordinate system as shown in FIG. 3A, for a given zoom configuration indexed as ($m, n$), the lateral coordinates of its corresponding lenslet can be expressed as

$$\begin{cases} u_0(m,n) = \dfrac{(2m-M-1)p_{MLA}}{2} \\ v_0(m,n) = \dfrac{(2n-N-1)p_{MLA}}{2} \end{cases} \quad . \qquad (1)$$

Although the microdisplay is also divided into an M by N array of EIs, one for each lenslet, the lateral position and size of each EI is more complex and dependent on several other specifications of the display system. For instance, the viewing window, which is not necessarily the optical conjugate of the MLA and can be shifted longitudinally along the optical axis according to a design requirement (see, e.g., FIG. 4A where X indicates a non-conjugate relationship), plays a vital role in dividing and configuring the whole system into a series of sub-systems. An array of imaged apertures is actually formed in the visual space, which is considered as being the exit pupil in the sense of a conventional display or imaging system. Placing a viewer's eye at this exit pupil location would however indicate that the viewer cannot simultaneously see all the EIs as the imaged apertures are spatially separated. To ensure that all of the EIs can be properly seen at the viewing window, the microdisplay is divided in such a way that the chief ray of the center of each EI through the whole display optics, including the corresponding lenslet of MLA and the shared eyepiece group, will intersect with the optical axis at the center of the viewing window, $O_v$ (e.g., solid lines in FIG. 4B that start at display and converge at viewing window). Under such constraint, the displacement between the adjacent EIs, $\Delta p_{EI}$, and the size of the elemental images, $p_{EI}$, on the microdisplay are equal and can be written as:

$$\Delta p_{EI} = p_{EI} = p_{MLA}\left(1 + \frac{g}{l + z_{IC} + z'_{xp}}\right). \qquad (2)$$

In Equation (2), $g$ is the gap between the display panel and MLA, $l$ is the gap between the MLA and the intermediate CDP, $z_{IC}$ is the gap between the intermediate CDP and the eyepiece group, and $z'_{xp}$ is introduced to refer to the distance between the eyepiece group and the imaged viewing window by the eyepiece group, which can be further given as:

$$z'_{xp} = \frac{f_{ep} z_{xp}}{z_{xp} - f_{ep}}. \qquad (3)$$

In Equation (3), $f_{ep}$ is the equivalent focal length of the eyepiece group. Therefore, for a given sub-system unit indexed as $(m, n)$, the lateral coordinates of the center of the corresponding EI can be expressed as:

$$\begin{cases} s_0(m,n) = \frac{(2m - M - 1)p_{EI}}{2} \\ t_0(m,n) = \frac{(2n - N - 1)p_{EI}}{2} \end{cases}. \qquad (4)$$

The footprint size, $d_v$, of the ray bundle from a pixel of an EI projected through the whole optics on the viewing window, which determines the view density or equivalently the total number of views encircled by the eye pupil, can be determined by tracing the ray bundles emitted by the center point of the EI (e.g. the shaded ray bundles in FIG. 4C), and the overall size of the viewing window, $D_v$, can determined by tracing the chief ray of the edge point of the EI through the whole display optics (e.g., the line starting at the edge of EI in FIG. 4C)). The ray footprint diameter and the overall viewing window size can be expressed as:

$$d_v = p_{MLA}\frac{z_{IC}}{l}\left|1 - \frac{z_{xp}}{f_{ep}} + \frac{z_{xp}}{z_{IC}}\right|, \qquad (5)$$

$$D_v = p_{EI}\frac{l + z_{IC}}{g}\left|1 - \frac{z_{xp}}{f_{ep}} + \frac{z_{xp}}{l + z_{IC}}\right|. \qquad (6)$$

In Equations (5) and (16), | ... | stand for the absolute value symbol.

According to the paraxial geometry, both the footprint diameter and the viewing window size are the same for any of the sub-systems, and the footprints corresponding to the same field object of different sub-systems will intersect on the viewing window so that they share the same coordinates $(x_v, y_v)$. For example, as mentioned above, the chief ray of the center of each EI will intersect with the optical axis at the center of the viewing window so that $x_{v0}(m, n)$ and $y_{v0}(m, n)$ both equal to zero for any of the sub-system.

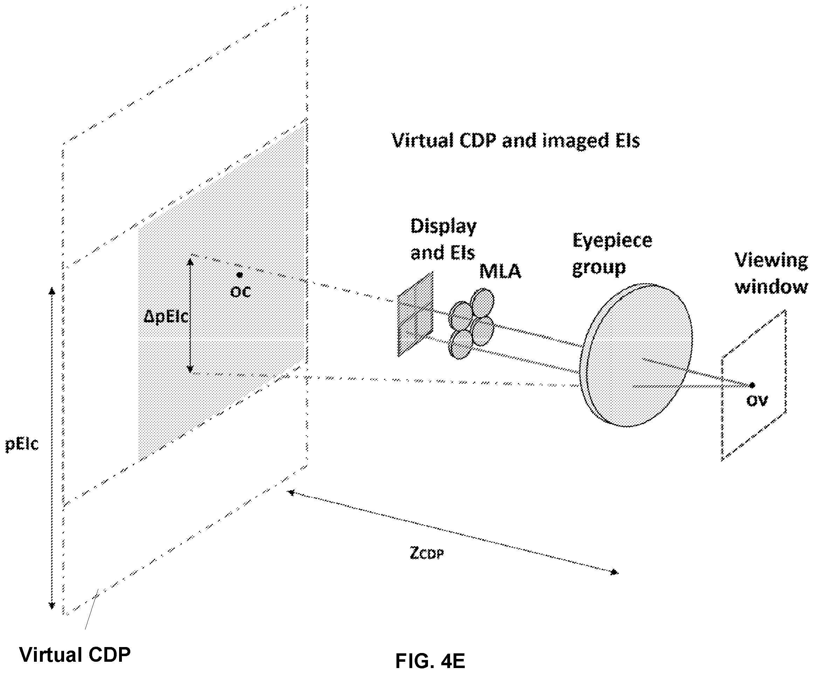

In an InI-HMD system, the EIs are seen as an array of spatially displaced virtual images observed from the viewing window. FIG. 4D illustrates a simple example where four neighboring EIs rendered on the microdisplay are imaged through their corresponding lenslets of MLA and the shared eyepiece and are projected on the virtual CDP as four partially overlapping virtual EIs as illustrated by the dashed boxes that overlap one another at the center shaded square. FIG. 4E is identical to FIG. 4D with the rays associated with two of the EI's removed to facilitate the understanding of the underlying principles. The displacement between centers of the neighboring virtual EIs on the virtual CDP, $\Delta p_{EIc}$, is no longer equal to the size of the virtual EIs, $p_{EIc}$, and their paraxial values are further expressed, respectively,

$$\Delta p_{EIc} = \Delta p_{EI} \frac{z'_{xp}}{g+l+z_{IC}+z'_{xp}} \frac{z_{CDP}}{z_{xp}}, \qquad (7)$$

$$p_{EIc} = p_{EI} \frac{l(z_{CDP}-z_{xp})}{g z_{IC}}. \qquad (8)$$

In Equations (7) and (8), $Z_{CDP}$ is the distance between the virtual CDP and the viewing window. For a given sub-system unit indexed as $(m, n)$, the lateral coordinates of the paraxial center of the corresponding virtual EI can be expressed as:

$$\begin{cases} x_{c0}(m,n) = \frac{(2m-M-1)\Delta p_{EIc}}{2} \\ y_{c0}(m,n) = \frac{(2n-N-1)\Delta p_{EIc}}{2} \end{cases}. \qquad (9)$$

Equations (7) and (9) essentially provide the paraxial calculations of the image dimension and center position for each of the sub-systems. The image size of the virtual EIs on the virtual CDP is usually much greater than the displacement of the neighboring virtual EIs so that the virtual EIs on the virtual CDP would partially overlap with each other. As illustrated in FIG. 4D, the shaded overlapped area on the virtual CDP corresponds to the region where all the four virtual EIs overlap with each other, and is where four distinctive elemental views, one from each of the EIs, can be rendered to reconstruct the light fields of a sub-volume of a scene seen from the viewing window. Due to this nature, the overall FOV of an InI-HMD is mosaiced by the sub-volumes rendered by each of the individual EIs and thus could not be straightforwardly calculated as in conventional HMDs. For simplicity, by referring to the centers of the virtual images of the edge EIs on the virtual CDP, the diagonal field of view (FOV) of the display system could be estimated as:

$$FOV_D = 2 \tan^{-1} \left( \sqrt{\frac{(M^2+N^2)}{2}} \frac{\Delta p_{EIc}}{z_{CDP}} \right). \qquad (10)$$

The above steps demonstrate the disclosed methods of modeling an LF-HMD system and analytic methods of calculating the first-order relationships of the system parameters. These steps are different from modeling a conventional 2D HMD and are critical for developing proper optimization strategies.

As stated earlier, the optimization strategy for an LF-HMD needs to properly control and evaluate optical aberrations that degrade the contrast and resolution of the virtual display or detort the geometry of the 2D elemental images, both individually and collectively, to account for the ray position sampling aspects of the light field. The optimization strategy also requires methods and metrics to control and evaluate the optical aberrations that degrades the accuracy of the directional ray sampling.

Ray Positional Sampling Considerations: Optimizing ray positional sampling of the light field function can be achieved by control optical aberrations that affect aberrations that degrade the contrast and resolution of the virtual display or detort the geometry of the 2D elemental images. It is helpful to obtain well-imaged EIs on the virtual CDP from the display panel through their corresponding lenslets of the MLA and eyepiece group.

The optimization strategy in accordance with the disclosed embodiments for ray positional sampling is multi-fold, and includes optimizing the imaging process of each EI individually by each of the sub-systems. For example, optimization constraints and performance metrics available in optimizing the 2D image-conjugates for conventional HMDs can be used. The exact constraints and performance metrics vary largely from system to system, heavily depending on the complexity of the optical components utilized in the optical systems for an InI-HMDs. Examples of typical constraints include, but are not limited to, the minimum and maximum values of element thickness or the spacings between adjacent elements, the total path length of the system, the allowable component sizes, shapes of each of the optical surfaces, surface sag departures from a reference surface, the type of optical materials to be used, the amount of tolerable aberrations, or the amount of optical power. Examples of performance metrics include, but are not limited to, root-mean-square (RMS) spot size, wavefront errors, the amount of residual aberrations, modulation transfer functions, or acceptable image contrast. With this initial stem, the entire FOV of the LF display composed by the individual EIs are optimized separately instead of being treated as a whole as in conventional HMD designs. Such an individual optimization for each of the EIs, however, overlooks the corresponding connection between the neighboring EIs and more importantly the relative positions and sizes of virtual EIs with respect to the total FOV. For an InI-HMD, as shown in FIG. 4D, the imaged EIs on the virtual CDP would be aligned perfectly and partially overlapping with neighboring ones, with the paraxial relationships given by Equations (7) through (9). However, image aberrations induced by both the MLA and the eyepiece group will distort the virtual EIs on the virtual CDP and the distorted virtual EIs will cause potential failure of view convergence when reconstructing the light fields of 3D scenes of different depths.

To account for the effects of distortions induced to the EIs locally and globally, two different types of constraints during optimization can be applied. The first constraint is the control of the local distortion aberrations for each of the sub-systems representing a single EI, which can be readily implemented by adopting the distortion-related optimization constraints already available in the optical design software to each zoom configuration. The exact constraints for local distortion control vary largely from system to system, heavily depending on the complexity of the optical components utilized in the optical systems for an InI-HMDs. Examples of typical controls on distortion include, but are not limited to, maximum allowable deviation of the image heights of the sampled object fields from their paraxial values, allowable percentile of image height and shape difference from a regular grid, allowable magnification differences of different object fields, or allowable shape deformation of the image from a desired shape, etc. These controls are typically applied as constraints to each sub-system individually to ensure each sub-system forms an image with acceptable local distortion. These local controls of distortion in each sub-system ensure the dimensions and shapes of the virtual EIs remain within a threshold level in comparison to their paraxial non-distorted images.

The second constraint is the control of the global distortion, which is related to the lateral positions of the virtual EIs with respect to the whole FOV of the reconstructed 3D scene. To optimize for this global distortion, the chief ray of the center object field of each EIs on the microdisplay is ought to be specially traced and its interception on the virtual CDP needs to be extracted and constrained within a threshold level comparing to its paraxial positions in global coordinates. For a given sub-system indexed as *(m, n)*, the global deviation of the center position of virtual EI on the virtual CDP from its paraxial position can be quantified by a possible metrics, GD, along with the corresponding constraints, which can be expressed as:

$$GD(m,n) = tan^{-1}\left(\frac{\sqrt{(x_c(m,n)-x'_c(m,n))^2+(y_c(m,n)-y'_c(m,n))^2}}{z_{CDP}}\right), \quad (11)$$

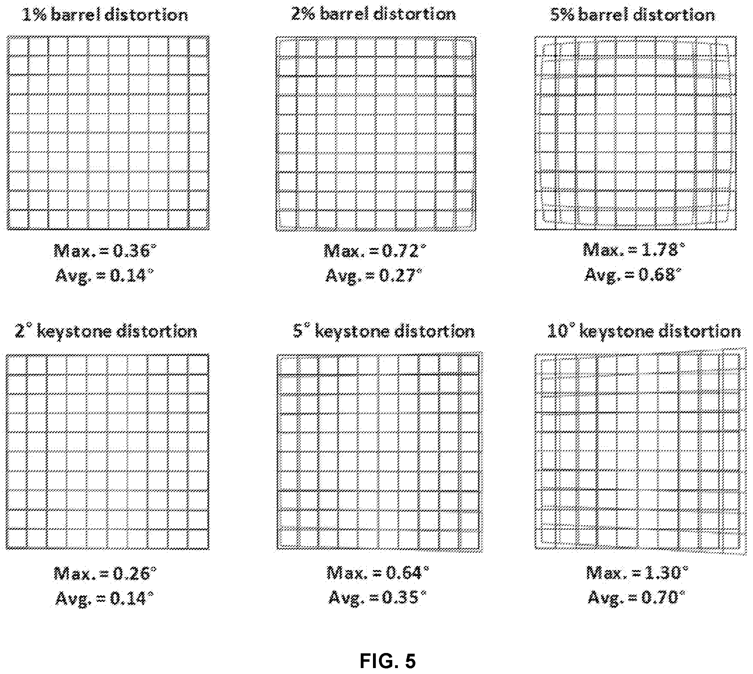

The GD metric in Equation (11) examines the angular deviation between the real and theoretical position of the chief ray of the center object field measured from the viewing window. For example, as illustrated in FIG. 5, different values of the GD metric can correspond to different amounts of distortion, thus allowing the system designer to select a proper target *GD* value that is suitable for a particular system. For example, in one particular system (e.g., due to cost and quality of components) a higher amount of distortion can be tolerated, which can inform the designer regarding the selection of the proper target *GD* value.

A constraint corresponding to the metric can therefore be created by obtaining the maximum values of the metric for all the EIs through all the sub-systems. By adding the constraint to the optimization process and modifying the value of the constraint, the maximally allowed global distortion can be adjusted and optimized. FIG. 5 further demonstrates the overall correlation between the global distortion and the value of *GD* by utilizing examples of barrel distortion and keystone distortion simulated in a 40° by 40° InI-HMD system with the depth of CDP at 1 diopter. In each of the sub-figures, both the full theoretical FOV grid free from global distortion (solid black) and the distorted FOV grid (slightly offset gray) corresponding to the specific type and value of distortion were plotted, and the numbers stand for the maximum and average value of *GD* calculated from Equation (11) for a total of 11 by 11 sampled centers of EIs (the intersection points of the grids). For example, while 1% barrel distortion yields a maximum GD of only 0.36°, 5% barrel distortion yields a maximum *GD* as large as 1.78°. Clearly, the value of *GD* provides a good control of the global distortion of the center positions of the EIs, either as conventional distortion pattern (e.g. barrel or pincushion distortion) or unconventional one (e.g. keystone distortion), in optimizing ray positions of the light field function

Ray Directional Sampling Considerations: due to the unique property of an LF-HMD, the ray directions of the light fields play a very important role in designing such a display system. Incorrect sampling of ray directions will not only affect the integration of the EIs but also potentially lead to uneven number of elemental views for reconstructed light field targets and thus misrepresented focus cues. In the case of severe pupil aberration, it is even possible that the number of elemental views encircled by a viewer's eye pupil reduces to be less than two so that the system becomes no different from a conventional stereoscopic display system and fails to properly render true light fields.

As noted above, the viewing window is where all the chief rays through the center pixels of all the EIs intersect with the optical axis, as shown in FIG. 3A, to ensure all of the EIs can be properly seen simultaneously. The footprints of the ray bundles projected from each of the elemental views, characterized by Equation (5), collectively define the viewing window with its paraxial dimension characterized by Equation (6). To optimize the ray directional sampling of light fields in designing LF-HMDs, proper constraints must be provided for the footprints of each elemental views projected on the viewing window rather than directly optimizing for the exit pupil(s) of the elemental views. For an InI-HMD with ideal ray directions of the light field function or equivalently free from pupil aberration, the merged footprint diagram at the viewing window should have two notable characteristics. First of all, the chief rays from different object fields on a single EI passing through the corresponding lenslet of the MLA as well as the eyepiece group should converge at the center of the imaged aperture and intersect with the viewing window in a regular grid with uniform spacing, resembling the pixel array of the EI. Secondly, the chief rays from the same object field (with respect to their own EIs) passing through their corresponding lenslets and eyepiece should converge at the viewing window, and the footprints of the ray bundles from these pixels should form the same shape and overlap perfectly with each other on the viewing window.

To optimize the ray directional sampling of light fields in designing LF-HMDs, proper constraints for the footprints of each elemental views projected on the viewing window must be provided. To account for the effects of pupil aberration induced to the ray footprints and directions on the viewing window during optimization, the disclosed optimization strategies (1) extract the exact footprints of the ray bundles from any given pixel of a given EI on the viewing window; and (2) establish metric functions that properly quantify any deviations of the ray footprints from their paraxial shapes and positions so that constraints can be applied during the optimization process to control the deviations within a threshold level.

In some embodiments, for each given object field, four marginal rays are sampled through the lenslet aperture to avoid exhaustive comptitation time during the optimization process. The coordinates of these marginal rays on the viewing window define the envelop of the ray footprint of a sampled field on a given EI in a given sub-systems. For a sampled object field indexed as $(i, j)$ on a given EI corresponding to a sampled sub-system indexed as $(m, n)$, the deformation of the ray footprints from its paraxial shape can be quantified by a metric function, $PA$, using, for example, the following:

$$PA(m, n, i, j) =$$

$$\frac{1}{4}\sum_{k=1}^{4} \frac{\sqrt{(x_{vk}(m,n,i,j) - x'_{vk}(m,n,i,j))^2 + (y_{vk}(m,n,i,j) - y'_{vk}(m,n,i,j))^2}}{\sqrt{2}d_v}. \qquad (12)$$

In Equation (12), $x'_v$ and $y'_v$ are the real positions of the marginal rays on the viewing window obtained via real ray tracing horizontally and vertically, respectively, while $x_v$ and $y_v$ are their corresponding paraxial positions on the viewing window. $k$ is the index of four marginal rays for a sampled object on a given EI corresponding to a sampled sub-system.

The metric $PA$ in Equation (12) quantifies the deformation of the ray footprint of a given ray bundle from its paraxial shape by examining the relative ratio of the average deviated distance between the real and theoretical positions of the marginal rays on the viewing window to the diagonal width of the paraxial footprint. By adding the constraint to the optimization process and modifying the value, the maximally allowed deviation and deformation of the footprint, or equivalently, the pupil aberration affecting the ray directions of the light field of an InI-HMD can be adjusted and optimized.

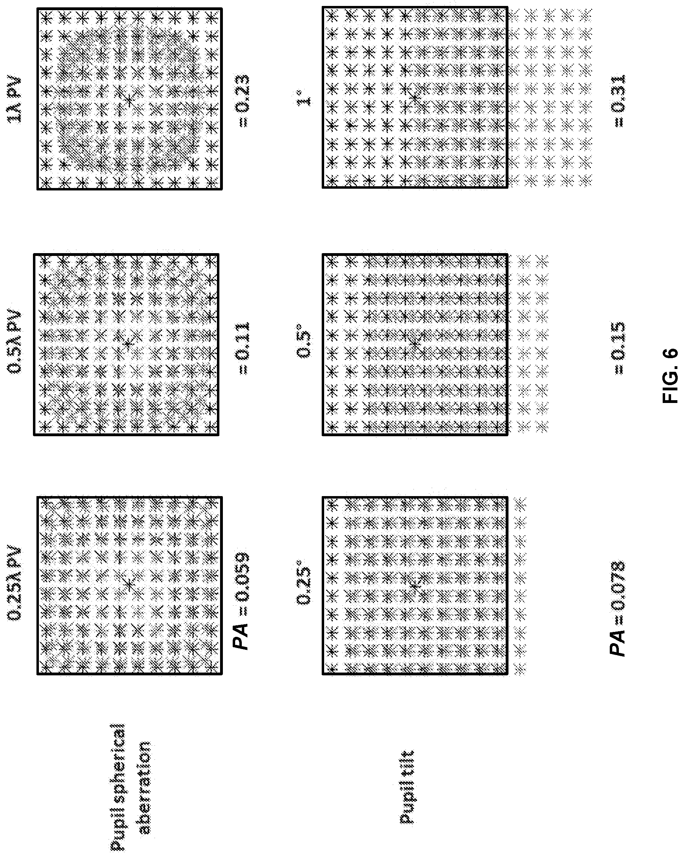

FIG. 6 illustrates the overall correlation between the footprint diagrams on the viewing window, pupil aberrations, and the metric function values of PA. A single constraint can thus be created by obtaining the maximum value of the metric form all the sampled object fields on each of the sampled sub-systems. The figures plot simulated ray footprint diagrams for the center field point of the EI centered with the optical axis of an InI-HMD, with and without pupil aberration. For simplicity, in the simulation the lenslets were treated as ideal lenses, and the eyepiece group was modeled with different aberration terms and magnitudes (e.g. spherical aberration from 0.25 to 1 waves peek to valley ($\lambda$PV), and tilt from 0.25 to 1°) applied as pupil aberration. Specifically, the diameter of the theoretical footprint, $d_v$, was set as 1 mm. In each of the sub-figures, both the theoretical footprint diagram free from pupil aberration (the set of 10-by-10 star-shaped points forming the square bounded by the solid line) and the deformed or displaced footprint diagram (the remaining star-shaped points) corresponding to the specific type and value of pupil aberration term were plotted. The number beneath each of the sub-figures stands for the value of $PA$ calculated from Equation (12) for each case. It can be observed that due to the presence of pupil aberration, the actual footprint diagrams can be significantly deformed (e.g., by pupil spherical aberration) or displaced (e.g., by tilt) from their theoretical footprint. Equation (12) makes a good estimation of the severity of the pupil aberration in terms of PA based on the footprint diagram. For example, 0.25 $\lambda$PV pupil spherical aberration yields a PA of only 0.059, while 1 $\lambda$PV pupil spherical aberration yields a PA as large as 0.23.

In using the above noted metrics, the system design can be carried out to determine optimum (or generally, desired or target) designs that include determinations of distances and angular alignment of components, sizes of components (e.g., pitch of lens lets, area of lenslets, surface profiles of lenslets and/or eyepiece, focal lengths, and apertures of the lenslets array and/or eyepiece, etc.). The system can further include additional optical elements, such as relay optics, element for folding or changing the light path, and others, that can be subject to ray tracing and optimization as part of the system design.

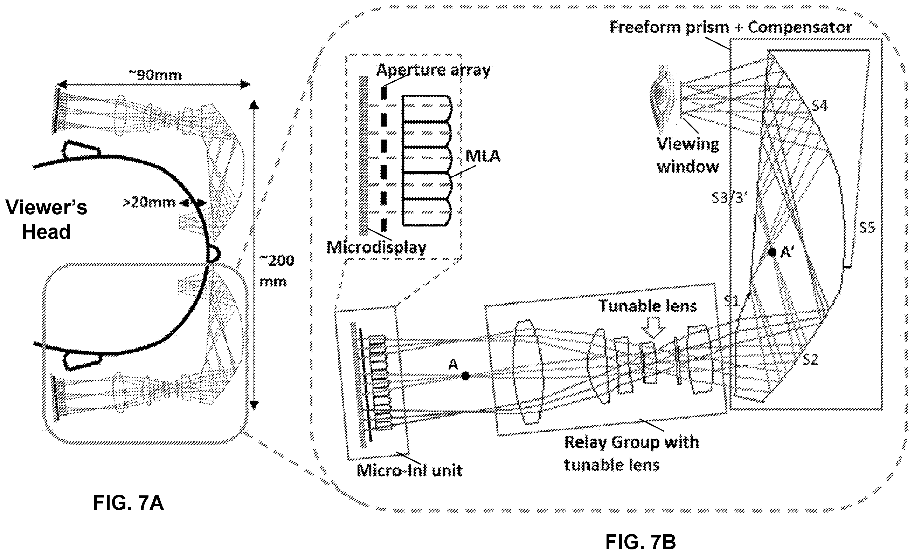

FIG. 7A illustrates an example layout of a binocular setup of InI-HMD system produced in accordance the disclosed design setup and optimization methods. In FIG. 7A, the system is illustrated with respect to a viewer's head. FIG.

7B provides further details regarding the optical layout of FIG. 7A with respect to its monocular setup (right eye) with key elements labelled. The top section of FIG. 7A follows a similar configuration as FIG. 7B. It should be noted that the distances and particular number of illustrated components are provided by the way of example, and not by limitation, to facilitate the understanding of the disclosed technology. As illustrated, the optics for the display path, which is of particular interest, includes three main subsections: a micro-INI unit including a high-resolution microdisplay, a custom-designed aspherical MLA, a custom aperture array, a tunable relay group comprising 4 lenses (e.g., stock spherical lenses with an Optotune® EL-10-30 tunable lens sandwiched inside), and a freeform waveguide-like prism. The waveguide-like prism, essentially formed by 4 freeform surfaces denoted as $S1$ to $S4$, further magnifies the reconstructed intermediate miniature scene and projects the light toward the exit pupil, or the viewing window, at which a viewer sees the magnified 3D scene reconstruction.

At the outset of the design for the example configuration, the MLA and the relay-eyepiece group were optimized separately to obtain good starting points due to the complexity of the system. For the initial iteration of the MLA design, special attention was paid to the marginal rays that were constrained to not surpass the edge of the lenslet to prevent crosstalk among neighboring EIs. The two surfaces of the lenslet were optimized as aspheric polynomials with coefficients up to 6th order. In the initial iteration for the design of the relay and eyepiece group, the design was reversely set up by backward tracing rays from the viewing window toward the eyepiece and relay lenses. Each of the four freeform surfaces of the prism was described by x-plane symmetric XY-polynomials and was optimized with coefficients up to their 10th order.

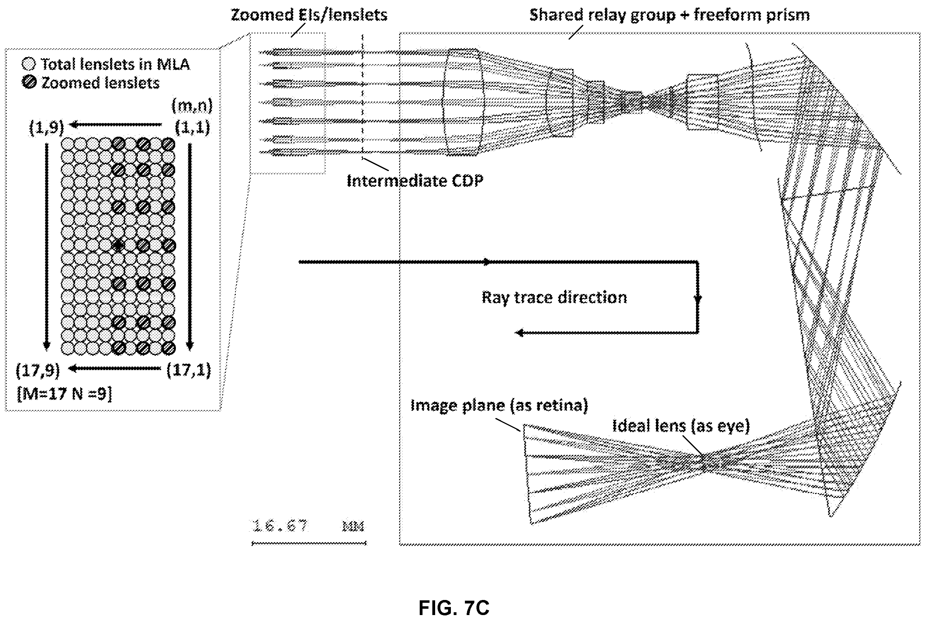

After obtaining the initial designs of both the MLA and the relay-eyepiece group, the two parts were integrated and an array of 7 by 3 zoom configurations was created. FIG. 7C shows the design configuration of the integrated display path in CodeV®, plotted with real ray tracing from a fraction of the sampled EIs and lenslets. The viewing window was placed at the back focal point of the freeform eyepiece. An ideal lens with a focal length equivalent to the eye focal power corresponding to the depth of the virtual CDP was inserted at the viewing window to simulate the retinal images of the EIs. In the figure only the rays from the center pixel of each EI were traced. The MLA included 17 by 9 identical lenslets with a lens pitch of 1mm, and the microdisplay was divided into 17 by 9 EIs, each with 125 by 125 pixels. Considering the plane symmetry of the freeform prism, a total of 7 by 3 sub-systems (EIs with corresponding lenslets of MLA) for the top half of the total FOV were sampled, and the distribution of the sampled sub-systems is shown in FIG. 7C as zoomed lenslets. In each sub-system, 9 field points were further sampled covering the whole EI. Besides, to account for DOF extension with varying optical power of the tunable lens as well as the depth of virtual CDP, the system was further configured to optimize its performance for the virtual CDP depths of 0, 1, and 3 diopters. The focal length of the ideal lens at the viewing window as well as the tunable lens is thus adjusted correspondingly to correctly focus the rays on to the image plane. Altogether, combining the zooms of for the 21 sampled MLA-EI sub-systems as well as the zooms for different virtual CDP depths, the overall system was modelled with a total 63 zoom configurations, and a total of 567 field points.

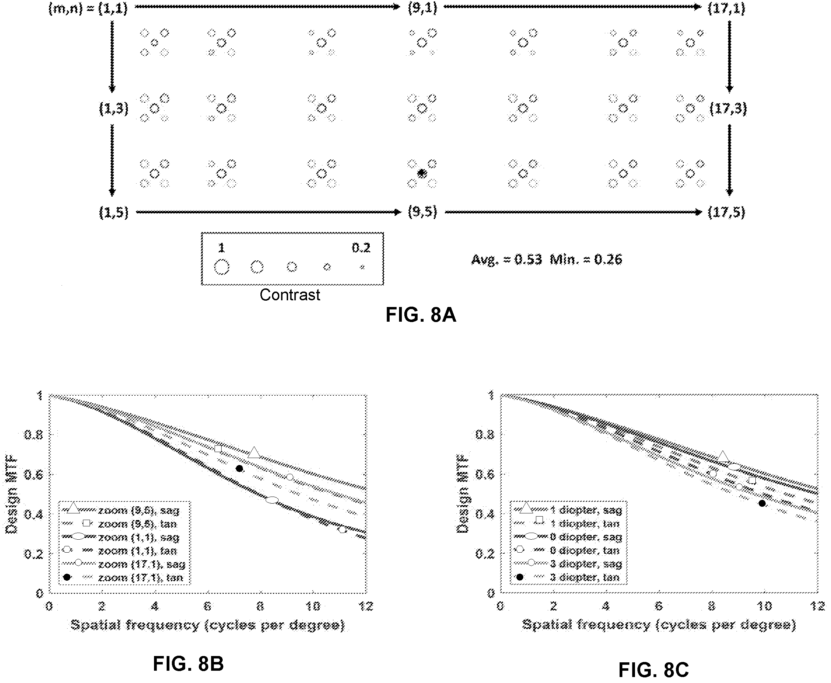

FIG. 8A plots the image contrast of the sampled 7 by 3 sub-systems covering the full field of the display path evaluated at the Nyquist angular frequency of 3 arcmins or 10 cycles/degree (cpd) with the virtual CDP set at 1 diopter away from the viewing window. In each of the sub-systems, five object fields on their corresponding EI were sampled and their contrast values are represented by circles, each at a specific location corresponding to each of the five object fields. Across the entire 30° by 18° of FOV the image contrast is all well above the threshold of 0.2 at the Nyquist angular frequency with an average of 0.53.

FIG. 8B plots the modulation transfer functions (MTFs) of the on-axis field points on three EIs corresponding to the lenslet centered with optical axis (index (9,5)), the top left corner lenslet (index (1,1)), and the top right corner lenslet (index (17,1)), respectively, covering the whole FOV of the display path. FIG. 7C further plots the MTFs of the on-axis field points on three EIs corresponding to the lenslet centered with the optical axis (index (9,5)) but with their virtual CDP adjusted from 3 diopters to 0 diopters away from the viewing window by adjusting the optical power of the tunable lens. It is clear that the optical system demonstrates uniform image contrast and MTF performance across the entire FOV and depth range of over 3 diopters with a degradation of image contrast evaluated at Nyquist angular frequency less than 0.15.

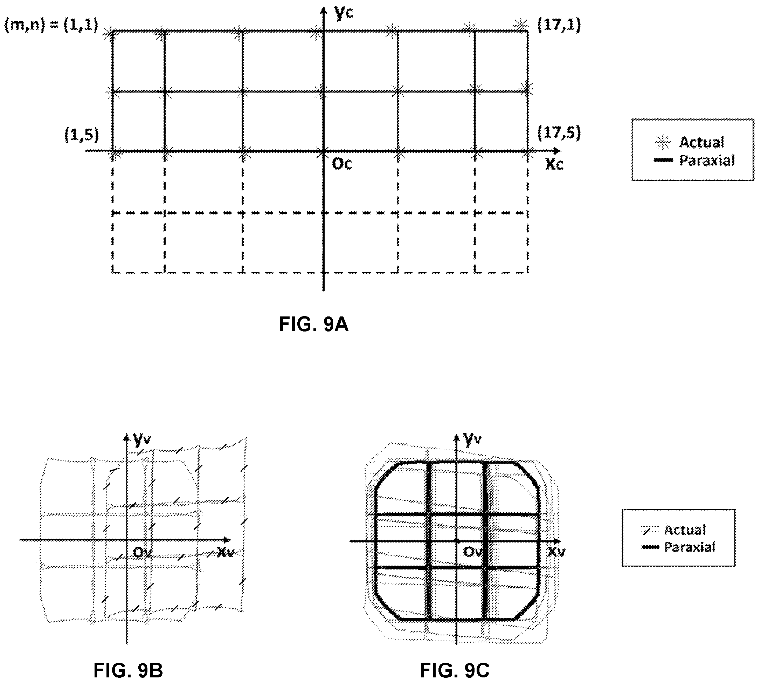

FIG. 9A further plots the global distortion grid of the sampled 7 by 3 sub-systems of the display path covering the full display FOV by extracting the chief ray coordinates of the center object field on the corresponding EI from each of the sub-systems from real ray tracing of the design example, where the paraxial coordinates of the chief rays are plotted in solid grid and the actual ray coordinates in asterisks. Though the display path suffers a small amount of keystone distortion due to the folded optical path, generally the global distortion for full display field is relatively small, especially for a design involving freeform optics which easily introduces high order distortion terms. The design target regarding the global distortion $GD$ was set as 0.75° which corresponding to around 2% of the distortion with respect to the full FOV. All of the 7 by 3 sub-systems were optimized within the design target with an average value of GD of 0.22° which corresponds to an average distortion with respect to the full FOV less than 1%.

FIGS. 9B and 8C compare the ray footprint diagrams at the viewing window before and after optimization regarding the ray directions of light field function. FIG. 9B plots the envelops of the ray footprints on the viewing window for the 9 sampled object fields of the on-axis lenslet (solid, index (9,5)) and the envelops for the 9 object fields of the edge lenslet located at the top-right corner (solid with a diagonal dash, index (17,1)) from the real design setup before constraining the pupil aberration of the system. The ray footprint envelops for these two lenslets are not only distorted but also severely separated. In comparison, FIG. 9C plots the merged envelops of the footprint diagrams extracted from the real design setup after optimization. In this case, the ray footprints through 9 sampled lenslets of the MLA are plotted (thin solid lines, indices (1,1), (9,1), (17,1), (1,3), (9,3), (17,3), (1,5), (9,5) and (17,5)). FIG. 8C also plots the theoretical envelops (in thick solid line) of the ray footprints of the same fields on the lenslets obtained from paraxial calculations which are perfectly aligned with each other across the lenslets and fields as suggested above. The design target $PA$ was set as 0.3 since the human vision system would be less sensitive to the ray directions than positions. Nineteen of the 7 by 3 sub-systems were optimized within the design target with an average ratio of 0.145 that is well below the design target, which corresponds to an average throughput or size deviation of the real footprints less than 0.27, of which the deviation and deformation of the projected footprints are still acceptable as shown in FIG. 9C.

In experiments, test result of a prototype InI-HMD system designed in accordance with the disclosed technology were obtained by placing the camera at the viewing window and capturing real images of the displayed scene through the system. Test scenes included a slanted wall with water drop texture spanning a depth from around 500mm (2 diopters) to 1600mm (0.6 diopters) that was computationally rendered and displayed as the test target. The central 15 by 7 elemental views rendered on the microdisplay were obtained, as well as real captured images of the rendered light fields of such a continuous 3D scene by adjusting the focal depth of the camera from the near side (~600mm), to the middle part (~1000mm), and the far side (~1400mm) of the scene, respectively, which simulates the adjustment of the eye accommodation from near to far distances. The virtual CDP of the prototype was shifted and fixed at depth of 750mm (1.33 diopters). The parts of the 3D scene within the same depth of the camera focus remained in sharp focus with high fidelity compared to the target. In contrast, the other parts of the 3D scene outside of the camera focal depth were blurry; the more the depth of the 3D scene was deviated from the camera focus, the blurrier were the part of the 3D scene, which is similar to what we observe from the real word scene. Such results clearly demonstrate the ability of the prototype designed in accordance with the disclosed embodiments to render high-quality light field contents, and more importantly, to render correct focus cues to drive the accommodation of the viewer's eye.

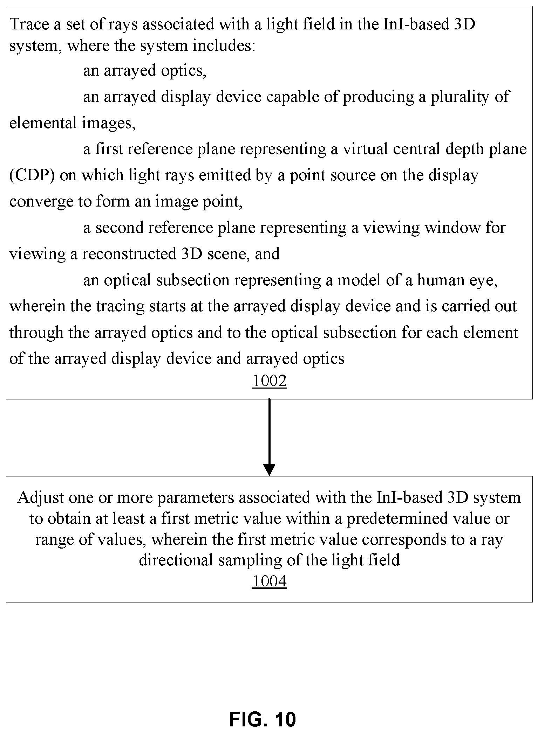

FIG. 10 illustrates a set of operations that can be carried out to implement a method for designing an integral-imaging (InI) based three-dimensional (3D) display system in accordance with an example embodiment. The method includes, at 1002, tracing a set of rays associated with a light field in the InI-based 3D system. The system includes an arrayed optics, an arrayed display device capable of producing a plurality of elemental images, a first reference plane representing a virtual central depth plane (CDP) on which light rays emitted by a point source on the display converge to form an image point, a second reference plane representing a viewing window for viewing a reconstructed 3D scene, and an optical subsection representing a model of a human eye. The tracing starts at the arrayed display device and is carried out through the arrayed optics and to the optical subsection for each element of the arrayed display device and arrayed optics. The method further includes, at 1004, adjusting one or more parameters associated with the InI-based 3D system to obtain at least a first metric value within a predetermined value or range of values, where the first metric value corresponds to a ray directional sampling of the light field.

In one example embodiment, the first metric value quantifies a deformation of ray footprint of a given ray bundle of the light field from its paraxial footprint. In another example embodiment, the first metric value is determined in accordance with a relative ratio of an average deviated distance between a real and a theoretical position of marginal rays on the second reference plane to a diagonal width of the paraxial footprint. In yet another example embodiment, the first metric value is determined in accordance with Equation (12). For example, the first metric value can be determined based on a difference real positions of marginal rays on the viewing window obtained by ray tracing and their corresponding paraxial positions on the viewing window.

According to another example embodiment, in the above noted method, adjusting the one or parameters associated with the InI-based 3D system is carried out to further obtain a second metric value within another predetermined value or range of values, where the second metric value corresponds to a ray positional sampling of the light field that accounts for deformations induced by neighboring elements of at least the arrayed optics. In one example embodiment, the second metric value is determined in accordance with an angular deviation between real and theoretical positions of a chief ray of a center object field measured from the second reference plane. In yet another example embodiment, the second metric value represents a global distortion measure. In still another example embodiment, the second metric value is determined in accordance with Equation (11). For example, the second metric value is computed as a deviation of a center position of a virtual elemental image of the plurality of the elemental images on the virtual CDP from a paraxial position thereof. In another example embodiment, adjusting the one or parameters associated with the InI-based 3D system is carried out with respect to the ray positional sampling of the light field to additionally optimize imaging of each EI individually.

In one example embodiment, the InI-based 3D system further includes an eyepiece positioned between the arrayed optics and the second reference plane, and tracing the set of rays includes tracing the set of rays through the eyepiece. In some embodiments, the arrayed display device is a microdisplay device. In some embodiments, the arrayed optics comprises one or more lenslet arrays, each including a plurality of microlenses. In another embodiment, the InI-

based 3D system is an InI-based head-mounted display (InI-based HMD) system.

In some embodiments, the predetermined value, or range of values, for one or both of the first or the second metric are selected to achieve a particular image quality. In some embodiments, the predetermined value, or range of values, for one or both of the first or the second metric represents a maxima or a minima that provides an optimum design criteria with respect to the first or the second metric.

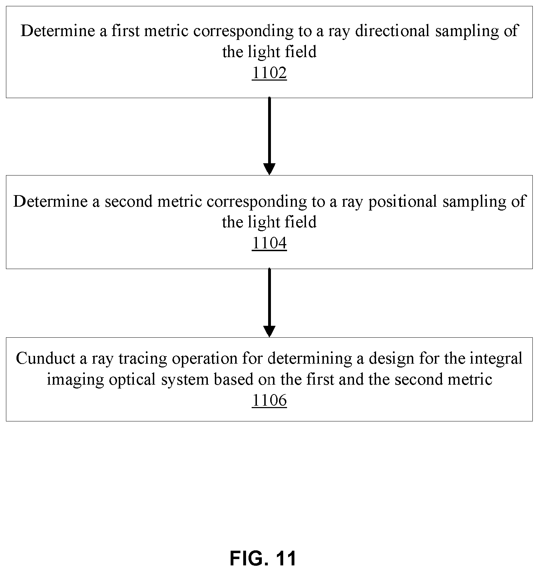

FIG. 11 illustrates a set of operations that can be carried out for improving design of an integral imaging optical system in accordance with an example embodiment. These operation can be carried out for an integral imaging optical system that includes a lenslet array that angularly samples directions of a light field producing an array of two-dimensional elemental images (EI), each representing a different perspective of a three-dimensional (3D). The method includes, at 1102, determining a first metric corresponding to a ray directional sampling of the light field; at 1104, determining a second metric corresponding to a ray positional sampling of the light field, and, at 1106, conducting a ray tracing operation for determining a design for the integral imaging optical system based on the first and the second metric. In some embodiments, the ray tracing operation is conducted based on one or more constraints that include maintaining the first or the second metric at a corresponding value or range of value.

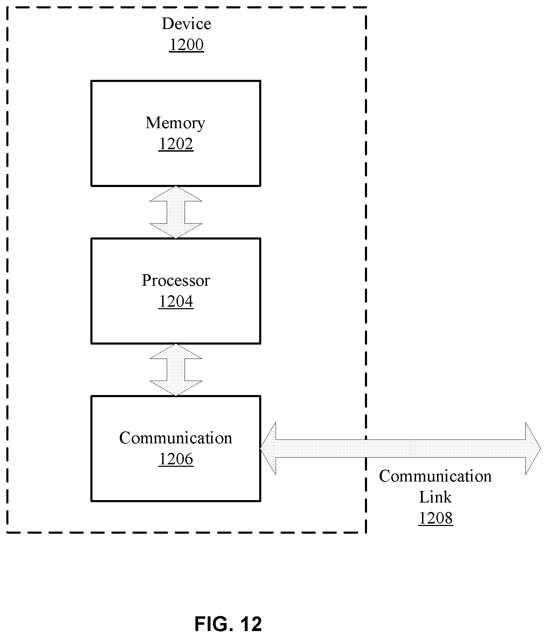

FIG. 12 illustrates a block diagram of a device 1200 that can be used to implement certain aspects of the disclosed technology. For example, the device of FIG. 12 can be used to receive, process, store, provide for display and/or transmit various data and signals associated with disclosed image sensors. The device 1200 comprises at least one processor 1204 and/or controller, at least one memory 1202 unit that is in communication with the processor 1204, and at least one communication unit 1206 that enables the exchange of data and information, directly or indirectly, through the communication link 1208 with other entities, devices, databases and networks. The communication unit 1206 may provide wired and/or wireless communication capabilities in accordance with one or more communication protocols, and therefore it may comprise the proper transmitter/receiver, antennas, circuitry and ports, as well as the encoding/decoding capabilities that may be necessary for proper transmission and/or reception of data and other information. The exemple device 1200 of FIG. 12 may be integrated as part of larger component (e.g., a server, a computer, tablet, smart phone, etc.) that can be used for performing various computations, methods or algorithms disclosed herein, such as to implement a ray-tracing program (e.g., Code V or Zemax) that are augmented to acconunodate the improvements that are disclosed in the present document.

The processor(s) 1204 may include central processing units (CPUs) to control the overall operation of, for example, the host computer. In certain embodiments, the processor(s) 1204 accomplish this by executing software or firmware stored in memory 1202. The processor(s) 1204 may be, or may include, one or more programmable general-purpose or special-purpose microprocessors, digital signal processors (DSPs), programmable controllers, application specific integrated circuits (ASICs), programmable logic devices (PLDs), graphics processing units (GPUs), or the like, or a combination of such devices.

The memory 1202 can be or can include the main memory of a computer system. The memory 1202 represents any suitable form of random access memory (RAM), read-only memory (ROM), flash memory, or the like, or a combination of such devices. In use, the memory 1202 may contain, among other things, a set of machine instructions which, when executed by processor 1204, causes the processor 1204 to perform operations to implement certain aspects of the presently disclosed technology.

It is understood that the various disclosed embodiments may be implemented individually, or collectively, in devices comprised of various optical components, electronics hardware and/or software modules and components. These devices, for example, may comprise a processor, a memory unit, an interface that are communicatively connected to each other, and may range from desktop and/or laptop computers, to mobile devices and the like. The processor and/or controller can perform various disclosed operations based on execution of program code that is stored on a storage medium. The processor and/or controller can, for example, be in communication with at least one memory and with at least one communication unit that enables the exchange of data and information, directly or indirectly, through the communication link with other entities, devices and networks. The communication unit may provide wired and/or wireless communication capabilities in accordance with one or more communication protocols, and therefore it may comprise the proper transmitter/receiver antennas, circuitry and ports, as well as the encoding/decoding capabilities that may be necessary for proper transmission and/or reception of data and other information.

Various information and data processing operations described herein may be implemented in one embodiment by a computer program product, embodied in a computer-readable medium, including computer-executable instructions, such as program code, executed by computers in networked environments. A computer-readable medium may include removable and non-removable storage devices including, but not limited to, Read Only Memory (ROM), Random Access Memory (RAM), compact discs (CDs), digital versatile discs (DVD), etc. Therefore, the computer-readable media that is described in the present application comprises non-transitory storage media. Generally, program modules may include routines, programs, objects, components, data structures, etc. that perform particular tasks or implement particular abstract data types. Computer-executable instructions, associated data structures, and program modules represent examples of program code for executing steps of the methods disclosed herein. The particular sequence of such executable instructions or associated data structures represents examples of corresponding acts for implementing the functions described in such steps or processes.

The invention is defined in the appended claims.

**Claims**

1.   A method for designing and optimizing an integral-imaging InI, based three-dimensional, 3D, display system, the method comprising:

tracing (1002) a set of rays associated with a light field in the InI-based 3D system, for designing and optimizing the InI-based 3D display system, the system including:

an arrayed optics comprising elements, the elements being microlenses or optical apertures,
an arrayed display device capable of producing a plurality of elemental images,
a first reference plane representing a virtual central depth plane (CDP) on which light rays emitted by a point source on the display converge to form an image point,
a second reference plane representing a viewing window for viewing a reconstructed 3D scene, and
an optical subsection representing a model of a human eye, wherein the tracing starts at the arrayed display device and is carried out through the arrayed optics and to the optical subsection for each element of the arrayed display device and arrayed optics; and

adjusting (1004) one or more parameters associated with the InI-based 3D system to obtain at least a first metric value within a predetermined value or range of values, wherein the first metric value corresponds to deformations of a footprint of a ray bundle from its paraxial footprint, said ray bundle representing a set of ray directional samples of the light field, and wherein the first metric value is determined in accordance with a relative ratio of an average deviated distance between a real and a theoretical position of marginal rays on the second reference plane to a diagonal width of the paraxial footprint, and wherein adjusting the one or more parameters associated with the InI-based 3D system is carried out to further obtain a second metric value within another predetermined value or range of values, wherein the second metric value corresponds to deformations of ray positional samples of the light field induced by neighboring elements of the arrayed optics;
designing and optimizing the InI-based 3D display system based on the determined first metric value and second metric value and adjusted one or more parameters.

2.   The method of claim 1, wherein the first metric value is determined based on a difference between real positions of marginal rays on the viewing window obtained by ray tracing and their corresponding paraxial positions on the viewing window.

3.   The method of claim 1, wherein the second metric value is determined in accordance with an angular deviation between real and theoretical positions of a chief ray of a center object field measured from the second reference plane.

4.   The method of claim 1, wherein the second metric value represents a global distortion measure.

5.   The method of claim 1, wherein the second metric value is computed as a deviation of a center position of a virtual elemental image of the plurality of the elemental images on the virtual CDP from a paraxial position thereof.

6.   The method of claim 1, wherein adjusting the one or more parameters associated with the InI-based 3D system is carried out with respect to the ray positional sampling of the light field to further optimize imaging of each elemental image individually.

7.   The method of claim 1, wherein the InI-based 3D system further includes an eyepiece positioned between the arrayed optics and the second reference plane, and wherein tracing the set of rays includes tracing the set of rays through the eyepiece.

8.   The method of claim 1, wherein the arrayed display device is a microdisplay device, or the arrayed optics comprises one or more lenslet arrays, each including a plurality of microlenses.

9.   The method of claim 1, wherein the InI-based 3D system is an InI-based head-mounted display (InI-based HMD) system.

10. The method of claims 1 or 5, wherein the predetermined values, or range of values, for one or both of the first or the second metric satisfy the following conditions:

   are selected to achieve a particular image quality or
   represent a maxima or a minima that provides an optimum design criteria with respect to the first or the second metric.

11. A device (1200) configured to perform the method for designing and optimizing the InI-based 3D display system according to claim 1, comprising:

   a processor (1204), and
   a memory (1202) comprising processor executable code, wherein upon execution by the processor cause the processor to perform the method for designing and optimizing of the InI based 3D display system recited in claim 1.

12. A non-transitory computer readable medium comprising instruction stored thereon, wherein the instructions, upon execution by the device according to claim 11, cause the process to execute the method for designing and optimizing the InI based 3D display system as recited in claim 1.

## Patentansprüche

1. Verfahren zum Entwerfen und Optimieren eines auf integraler Bildgebung, Int, basierenden dreidimensionalen, 3D, Anzeigesystems, wobei das Verfahren umfasst:
   Verfolgen (1002) einer Menge von Strahlen, die einem Lichtfeld in dem Int-basierten 3D-Anzeigesystem zugeordnet sind, um das Int-basierte 3D-Anzeigesystem zu entwerfen und zu optimieren, wobei das System umfasst:

   eine Array-Optik, die Elemente umfasst, wobei die Elemente Mikrolinsen oder optische Aperturen sind,
   eine Array-Anzeigevorrichtung, die in der Lage ist, eine Vielzahl von Elementarbildern zu erzeugen,
   eine erste Referenzebene, die eine virtuelle zentrale Tiefenebene (CDP) darstellt, auf der Lichtstrahlen, die von einer Punktquelle an der Anzeige emittiert werden, konvergieren, um einen Bildpunkt zu bilden,
   eine zweite Referenzebene, die ein Betrachtungsfenster zum Betrachten einer rekonstruierten 3D-Szene darstellt, und
   einen optischen Teilbereich, der ein Modell eines menschlichen Auges darstellt, wobei das Verfolgen an der Array-Anzeigevorrichtung beginnt und durch die Array-Optik hindurch und bis zu dem optischen Teilbereich für jedes Element der Array-Anzeigevorrichtung und der Array-Optik ausgeführt wird; und
   Anpassen (1004) eines oder mehrerer Parameter, die dem Int-basierten 3D-System zugeordnet sind, um mindestens einen ersten Metrikwert innerhalb eines vorbestimmten Wertes oder Wertebereichs zu erzielen, wobei der erste Metrikwert Verformungen einer Messpunktfläche eines Strahlenbündels gegenüber seiner paraxialen Messpunktfläche entspricht, wobei das Strahlenbündel eine Menge von gerichteten Strahlenproben des Lichtfeldes darstellt, und wobei der erste Metrikwert gemäß einem relativen Verhältnis eines durchschnittlichen abgelenkten Abstands zwischen einer tatsächlichen und einer theoretischen Position von Randstrahlen auf der zweiten Referenzebene zu einer Diagonalbreite der paraxialen Messpunktfläche bestimmt wird, und wobei das Anpassen des einen oder der mehreren Parameter, die dem Int-basierten 3D-System zugeordnet sind, ausgeführt wird, um ferner einen zweiten Metrikwert innerhalb eines anderen vorbestimmten Wertes oder Wertebereichs zu erzielen, wobei der zweite Metrikwert Verformungen von Strahlenpositionsproben des Lichtfeldes entspricht, die durch benachbarte Elemente der Array-Optik induziert werden; und
   Entwerfen und Optimieren des Int-basierten 3D-Anzeigesystems basierend auf dem bestimmten ersten Metrikwert und dem zweiten Metrikwert und dem einen oder den mehreren angepassten Parametern.

2. Verfahren nach Anspruch 1, wobei der erste Metrikwert basierend auf einer Differenz zwischen den tatsächlichen Positionen von Randstrahlen in dem Betrachtungsfenster, die durch Raytracing erzielt werden, und ihren entsprechenden paraxialen Positionen in dem Betrachtungsfenster bestimmt wird.

3. Verfahren nach Anspruch 1, wobei der zweite Metrikwert gemäß einer Winkelabweichung zwischen den tatsächlichen und theoretischen Positionen eines Hauptstrahls eines mittleren Objektfeldes, die von der zweiten Referenzebene aus gemessen wird, bestimmt wird.

**4.** Verfahren nach Anspruch 1, wobei der zweite Metrikwert eine globale Verformungsmessung darstellt.

**5.** Verfahren nach Anspruch 1, wobei der zweite Metrikwert als eine Abweichung einer mittleren Position eines virtuellen Elementarbildes der Vielzahl der Elementarbilder auf der virtuellen CDP gegenüber einer paraxialen Position desselben berechnet wird.

**6.** Verfahren nach Anspruch 1, wobei das Anpassen des einen oder der mehreren Parameter, die dem Int-basierten 3D-System zugeordnet sind, mit Bezug auf die Strahlenpositionsabtastung des Lichtfeldes ausgeführt wird, um die Bildgebung jedes Elementarbildes einzeln zu optimieren.

**7.** Verfahren nach Anspruch 1, wobei das Int-basierte 3D-System ferner ein Okular umfasst, das zwischen der Array-Optik und der zweiten Referenzebene positioniert ist, und wobei das Verfolgen der Strahlenmenge das Verfolgen der Strahlenmenge durch das Okular hindurch umfasst.

**8.** Verfahren nach Anspruch 1, wobei die Array-Anzeigevorrichtung ist eine Mikroanzeigevorrichtung ist, oder die Array-Optik ein oder mehrere Elementarlinsen-Arrays umfasst, die jeweils eine Vielzahl von Mikrolinsen umfassen.

**9.** Verfahren nach Anspruch 1, wobei das Int-basierte 3D-System ein Int-basiertes Datenhelm- (Int-basiertes HMD-) System ist.

**10.** Verfahren nach Anspruch 1 oder 5, wobei die vorbestimmten Werte oder der Wertebereich für eine oder beide von der ersten oder der zweiten Metrik die folgenden Bedingungen erfüllen:

sie werden ausgewählt, um eine bestimmte Bildqualität zu erreichen, oder
sie stellen ein Maximum oder ein Minimum dar, das optimale Entwurfskriterien mit Bezug auf die erste oder die zweite Metrik bereitstellt.

**11.** Vorrichtung (1200), die dazu konfiguriert ist, das Verfahren zum Entwerfen und Optimieren des Int-basierten 3D-Anzeigesystems nach Anspruch 1 auszuführen, umfassend:

einen Prozessor (1204), und
einen Speicher (1202), der prozessorausführbaren Code umfasst, der bei der Durchführung durch den Prozessor bewirkt, dass der Prozessor das Verfahren zum Entwerfen und Optimieren des Int-basierten 3D-Anzeigesystems nach Anspruch 1 ausführt.

**12.** Nicht vorübergehendes, computerlesbares Medium, das Anweisungen umfasst, die darauf gespeichert sind, wobei die Anweisungen bei der Durchführung durch die Vorrichtung nach Anspruch 11 bewirken, dass der Prozess das Verfahren zum Entwerfen und Optimieren des Int-basierten 3D-Anzeigesystems nach Anspruch 1 durchführt.

**Revendications**

**1.** Procédé de conception et d'optimisation d'un système d'affichage tridimensionnel 3D basé sur une imagerie intégrale InI, le procédé comprenant :
le tracé (1002) d'un ensemble de rayons associés à un champ lumineux dans le système 3D basé sur InI pour la conception et l'optimisation du système d'affichage 3D basé sur InI, le système incluant :

une optique matricielle constituée d'éléments, ces éléments étant des microlentilles ou des ouvertures optiques,
un dispositif d'affichage matriciel capable de produire une pluralité d'images élémentaires,
un premier plan de référence représentant un plan de profondeur central virtuel (CDP - Central Depth Plane) sur lequel convergent les rayons lumineux émis par une source ponctuelle sur l'écran pour former un point d'image,
un deuxième plan de référence représentant une fenêtre de visualisation pour visualiser une scène 3D reconstruite, et
une sous-section optique représentant un modèle d'œil humain, dans lequel le tracé commence sur le dispositif d'affichage matriciel et est mis en œuvre à travers l'optique matricielle et jusqu'à la sous-section optique pour chaque élément du dispositif d'affichage matriciel et de l'optique matricielle ;
le réglage (1004) d'un ou plusieurs paramètres associés au système 3D basé sur InI pour obtenir au moins une première valeur de métrique dans une valeur ou une plage de valeurs prédéterminée, dans lequel la première valeur de métrique correspond aux déformations d'une empreinte d'un faisceau de rayons par rapport à son empreinte paraxiale, ledit faisceau de rayons représentant un ensemble d'échantillons directionnels de rayons du champ lumineux, et dans lequel la première valeur de métrique est déterminée conformément à un rapport relatif d'une distance déviée moyenne entre une position réelle et une position théorique des rayons marginaux sur le deuxième plan de référence à une largeur diagonale de l'empreinte paraxiale, et dans lequel le réglage desdits un ou plusieurs paramètres associés au système 3D basé sur InI est mis en œuvre pour obtenir en outre une deuxième valeur de métrique dans une autre valeur ou plage de valeurs prédéterminée, dans lequel la deuxième valeur de métrique correspond aux déformations d'échantillons de position de rayons du champ lumineux induites par des éléments voisins de l'optique matricielle ; et

la conception et l'optimisation du système d'affichage 3D basé sur InI sur la base de la première valeur de métrique et de la deuxième valeur de métrique déterminées, et d'un ou plusieurs paramètres réglés.

2. Procédé selon la revendication 1, dans lequel la première valeur de métrique est déterminée sur la base d'une différence entre les positions réelles de rayons marginaux sur la fenêtre de visualisation obtenues par un tracé des rayons et leurs positions paraxiales correspondantes sur la fenêtre de visualisation.

3. Procédé selon la revendication 1, dans lequel la deuxième valeur de métrique est déterminée conformément à un écart angulaire entre la position réelle et la position théorique d'un rayon principal d'un champ d'objet central mesuré à partir du deuxième plan de référence.

4. Procédé selon la revendication 1, dans lequel la deuxième valeur de métrique représente une mesure de distorsion globale.

5. Procédé selon la revendication 1, dans lequel la deuxième valeur de métrique est calculée comme un écart entre la position centrale d'une image élémentaire virtuelle de la pluralité d'images élémentaires sur le CDP virtuel et sa position paraxiale.

6. Procédé selon la revendication 1, dans lequel le réglage desdits un ou plusieurs paramètres associés au système 3D basé sur InI est mis en œuvre en ce qui concerne l'échantillonnage positionnel des rayons du champ lumineux afin d'optimiser davantage l'imagerie de chaque image élémentaire individuellement.

7. Procédé selon la revendication 1, dans lequel le système 3D basé sur Ini inclut en outre un oculaire positionné entre l'optique matricielle et le deuxième plan de référence, et dans lequel le tracé de l'ensemble de rayons inclut le tracé de l'ensemble de rayons à travers l'oculaire.

8. Procédé selon la revendication 1, dans lequel le dispositif d'affichage matriciel est un dispositif de micro-affichage, ou l'optique matricielle comprend un ou plusieurs réseaux de microlentilles incluant chacun une pluralité de microlentilles.

9. Procédé selon la revendication 1, dans lequel le système 3D basé sur InI est un système d'affichage tête haute (HMD - Head-Mounted Display) basé sur InI.

10. Procédé selon les revendications 1 ou 5, dans lequel les valeurs ou les plages de valeurs prédéterminées de la première métrique et/ou de la deuxième métrique satisfont aux conditions suivantes :

elles sont sélectionnées pour obtenir une qualité d'image particulière, ou
elles représentent un maximum ou un minimum qui fournit un critère de conception optimal par rapport à la première métrique ou à la deuxième métrique.

11. Dispositif (1200) configuré pour exécuter le procédé de conception et d'optimisation du système d'affichage 3D basé sur InI selon la revendication 1, comprenant :

un processeur (1204), et
une mémoire (1202) comprenant un code exécutable par un processeur, dans lequel l'exécution par le processeur commande l'exécution du procédé de conception et d'optimisation du système d'affichage 3D basé sur InI selon la revendication 1.

12. Support non volatil lisible par un ordinateur sur lequel sont stockées des instructions, dans lequel les instructions, lors de leur exécution par le dispositif selon la revendication 11, commandent au processeur d'exécuter le procédé de conception et d'optimisation du système d'affichage 3D basé sur InI selon la revendication 1.

FIG. 1A

FIG. 1B

FIG. 2A

FIG. 2B

EP 4 014 483 B1

FIG. 3A

EP 4 014 483 B1

FIG. 3B

EP 4 014 483 B1

**Display and EI**

**Eyepiece group**

**Lenslets of MLA**

Viewing
window

Footprints

Imaged
lenslet
apertures

Optically
conjugate

EP 4 014 483 B1

**FIG. 4A**

FIG. 4B

FIG. 4C

Virtual CDP and imaged EIs

Display
and EIs
MLA

Eyepiece
group

Viewing
window

oc

$\Delta pEIc$

ov

pEIc

$Z_{CDP}$

Virtual CDP

FIG. 4D

Virtual CDP and imaged EIs

Display and EIs
MLA

Eyepiece group

Viewing window

$\Delta p EIc$

oc

ov

pEIc

$Z_{CDP}$

Virtual CDP

FIG. 4E

1% barrel distortion

2% barrel distortion

5% barrel distortion

Max. = 0.36°
Avg. = 0.14°

Max. = 0.72°
Avg. = 0.27°

Max. = 1.78°
Avg. = 0.68°

2° keystone distortion

5° keystone distortion

10° keystone distortion

Max. = 0.26°
Avg. = 0.14°

Max. = 0.64°
Avg. = 0.35°

Max. = 1.30°
Avg. = 0.70°

FIG. 5

FIG. 6

FIG. 7A

FIG. 7B

FIG. 7C

FIG. 8A

FIG. 8B

FIG. 8C

EP 4 014 483 B1

EP 4 014 483 B1

(m,n) = (1,1)                                    (17,1)

$y_c$

(1,5)                                            (17,5)

$O_c$                    $x_c$

Actual
Paraxial

**FIG. 9A**

$y_v$

$O_v$    $x_v$

**FIG. 9B**

$y_v$

$O_v$    $x_v$

Actual
Paraxial

**FIG. 9C**

Trace a set of rays associated with a light field in the InI-based 3D system, where the system includes:

an arrayed optics, an arrayed display device capable of producing a plurality of elemental images,

a first reference plane representing a virtual central depth plane (CDP) on which light rays emitted by a point source on the display converge to form an image point,

a second reference plane representing a viewing window for viewing a reconstructed 3D scene, and

an optical subsection representing a model of a human eye, wherein the tracing starts at the arrayed display device and is carried out through the arrayed optics and to the optical subsection for each element of the arrayed display device and arrayed optics
<u>1002</u>

Adjust one or more parameters associated with the InI-based 3D system to obtain at least a first metric value within a predetermined value or range of values, wherein the first metric value corresponds to a ray directional sampling of the light field
<u>1004</u>

**FIG. 10**

Determine a first metric corresponding to a ray directional sampling of the light field
1102

Determine a second metric corresponding to a ray positional sampling of the light field
1104

Cunduct a ray tracing operation for determining a design for the integral imaging optical system based on the first and the second metric
1106

**FIG. 11**

Device
1200

Memory
1202

Processor
1204

Communication
1206

Communication
Link
1208

**FIG. 12**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 62885460

**Non-patent literature cited in the description**

• **HUANG HEKUN et al.** Effects of ray position sampling on the visual responses of 3D light field displays. *OPTICS EXPRESS*, 18 March 2019, vol. 27 (7)

• **HUANG HEKUNET**. Systematic characterization and optimization of 3D light field displays. *OPTICS EXPRESS*, 24 July 2017, vol. 25 (16)